# EUROPEAN PATENT SPECIFICATION

(11) **EP 1 602 982 B1**
(45) Date of publication and mention of the grant of the patent: **18.12.2013**
(21) Application number: 05011688.8
(22) Date of filing: 31.05.2005
(51) Int. Cl.: G03F 7/00, G03F 7/30, G03F 7/32

(54) **Planographic printing method**
Flachdruckverfahren
Procédé d'impression planographique

(30) Priority: 31.05.2004 JP 2004161252; 25.06.2004 JP 2004188420; 06.08.2004 JP 2004230949; 13.08.2004 JP 2004235842
(43) Date of publication of application: 07.12.2005
(60) Divisional application: 13164470.0
(73) Proprietor: FUJIFILM Corporation, Minato-ku Tokyo (JP)
(72) Inventor: Mitsumoto, Tomoyoshi, Yoshida-cho, Haibara-gun, Shizuoka (JP); Inno, Toshifumi, Yoshida-cho, Haibara-gun, Shizuoka (JP)
(74) Representative: HOFFMANN EITLE

(56) References cited:
- EP-A- 1 132 200
- US-A- 5 258 263
- US-A- 5 853 958
- US-A1- 2002 177 074
- US-A1- 2003 010 240

## Description

### Background of the Invention

### 1. Field of the Invention

The present invention relates to a planographic printing method, and more particularly to a planographic printing method improved in an on-press developability and an inking property.

### 2. Description of the Related Art

In general, a lithographic printing plate has a surface formed by an oleophilic image area and a hydrophilic non-image area. The planographic printing is a printing method of providing such plate surface with a fountain solution and a printing ink alternately, thus, based on mutually repellent properties of water and oil, to utilize the hydrophilic non-image area as a fountain solution receiving area (ink non-receiving area) and to accept the ink only in the oleophilic image area and then transferring the ink onto a printing medium such as a paper thereby executing a printing.

For preparing such lithographic printing plate, there is widely employed a lithographic printing plate precursor (presensitized plate or PS plate) prepared by forming an oleophilic photosensitive resin layer (image recording layer) on a hydrophilic substrate. Ordinarily, a lithographic printing plate is obtained by a platemaking process of exposing the lithographic printing plate precursor to a light through an original image such as a lithographic film to cause the image recording layer in the image area to remain and then by eliminating the image recording layer in another unnecessary area with an alkaline developing solution or an organic solvent to expose a surface of the hydrophilic substrate thereby forming the non-image area.

The prior platemaking process for the lithographic printing plate precursor requires, after the exposure, a step of dissolving and eliminating the unnecessary image recording layer with a developing solution or the like, and a simplification in such additional wet process is considered as one of issues to be solved. As one method for such simplification, a developability with an almost neutral aqueous solution or with mere water is desired.

On the other hand, digital technologies for electronically processing, accumulation and output of image information with a computer are becoming widely popular, and various new image output methods matching such digital technologies are commercialized. As a result of such trend, a computer-to-plate technology, which directly prepares a lithographic printing plate without utilizing a lithographic film, by modulating a highly converging radiation such as a laser beam with digitized image information and scan exposing the lithographic printing plate precursor with such light, is attracting attention. Therefore, one of important technical targets is to provide a lithographic printing plate precursor matching such technology.

Based on such background, a simplification in the platemaking process and a matching with the digital technology are being more strongly desired than in the past.

In this connection, for example US-A-2003 010240 or JP-A No. 2002-365789 describe that, in a lithographic printing plate precursor having an image forming layer, containing a hydrophobic precursor, a hydrophilic resin and a photothermal converting agent, an inclusion of a compound having an ethylene oxide chain in the image forming layer enables a printing by an on-press development or by a wet developing process with water or a suitable aqueous solution as a developing solution, after an exposure.

Also USP-A No. 2004/0013968 describes a processing method for a lithographic printing plate precursor by preparing a lithographic printing plate precursor constituted of (i) a hydrophilic substrate, and (ii) an oleophilic heat-sensitive layer which contains a radical-polymerizable ethylenic unsaturated monomer, a radical polymerization initiator and an infrared absorbing dye and which is cured by an infrared laser exposure, contains water by 60 mass% or higher and is developable with an aqueous developing solution of a pH value of 2.0 - 10.0, executing an imagewise exposure with an infrared laser and eliminating an uncured area of the heat-sensitive layer with the aqueous developing solution. However, such technologies are still insufficient in a developability or in a printing run length.

As another simplified platemaking method, there is proposed a method called on-prcss development, employing an image recording layer of which an unnecessary portion can be removed in an ordinary printing process and removing the unnecessary portion of the image recording layer, after an exposure, on a printing press to obtain a lithographic printing plate.

For achieving such on-press development, there can be conceived, for example, a method of employing a lithographic printing plate precursor having an image recording layer that can be dissolved or dispersed in a fountain solution, an ink solvent, or an emulsion of the fountain solution and the ink, a method of mechanically removing the image recording layer by a contact with a roller or a blanket of the printing press, or a method of reducing a coagulating power of the image recording layer or an adhesion between the image recording layer and a substrate by a penetration of a fountain solution or an ink solvent and then mechanically removing the image recording layer by a contact with a roller or a blanket of the printing press.

For example, Japanese Patent No. 2938397 describes a lithographic printing plate precursor having, on a hydrophilic substrate, an image forming layer formed by dispersing hydrophobic thermoplastic polymer particles in a hydrophilic binder. Such lithographic printing plate precursor, after an image formation by a thermal fusion of the hydrophobic thermoplastic polymer particles under an imagewise exposure with an infrared laser, is mounted on a cylinder of a printing press and can be on-press developed by a fountain solution and/or an ink.

However, such method of forming an image by mere thermal fusion of fine particles, though showing a satisfactory on-press developability, shows an extremely weak image strength (adhesion to the substrate) and has an insufficient printing run length.

Also JP-A No. 2001-277740 and JP-A No. 2001-277742 describe a lithographic printing plate precursor, including microcapsules incorporating a polymerizable compound. Also JP-A No. 2002-287334 describes a lithographic printing plate precursor having, on a substrate, a photosensitive layer including an infrared absorbing agent, a radical polymerization initiator and a polymerizable compound. These methods utilizing a polymerization reaction provide a relatively good image strength because of a high density of chemical bonds in an image area, in comparison with the image area formed by the thermal fusion of the polymer particles. However, the on-press developable lithographic printing plate precursor utilizing such polymerization reaction can provide an improvement in the run length, but is insufficient in the practical on-press developability. Also for enabling an on-press development, the on-press developable lithographic printing plate precursor has to contain a considerable amount of a hydrophilic component in the image recording layer, and is therefore inferior in an inking property.

### Summary of the Invention

The present invention is to solve the aforementioned problems. Thus, an object of the present invention is to provide a planographic printing method with a lithographic printing plate precursor including an on-press development, excellent in a developability and an inking property.

According to the present invention, there is provided a planographic printing method comprising:
imagewise exposing a lithographic printing plate precursor comprising an image recording layer removable with at least one of a printing ink and a fountain solution, so as to cure an exposed portion of the image recording layer;
contacting the lithographic printing plate precursor with an aqueous solution containing a hydrophobic organic compound and a water-soluble polymer compound; and supplying a printing ink and a fountain solution, so as to execute a printing operation.

Preferably the image recording layer includes (1) a polymerization initiator and (2) a polymerizable compound.

Preferably the image recording layer includes microcapsules.

Preferably the image recording layer is ultraviolet sensitive or infrared sensitive.

Preferably the imagewise exposure is executed with a laser emitting light of a wavelength within the range of 760 to 1,200 nm or 250-420 nm.

Preferably the content of the water-soluble polymer compound in the aqueous solution is 0.1-20 mass %.

Preferably the aqueous solution further comprises a chelate compound.

Preferably the lithographic printing plate further comprises:
a substrate; and
an undercoat layer comprising a compound having a polymerizable group and a group adsorbable to the substrate selected from a sulfonic acid group, a phosphoric acid group and a phosphate ester,
wherein the substrate, the undercoat layer and the image recording layer are provided in this order.

In the planographic printing method of the invention, the lithographic printing plate precursor is contacted, after the imagewise exposure, with an aqueous solution containing a hydrophobic organic compound and a water-soluble polymer compound whereby it is estimated that the hydrophobic organic compound is adsorbed on the image area, cured by the exposure, to form an oleophilic surface thereby improving the inking property and the hydrophobic organic compound together with the hydrophilic component penetrates into the unexposed and uncured image recording layer thereby improving the developing property.

### Brief Description of the Drawings

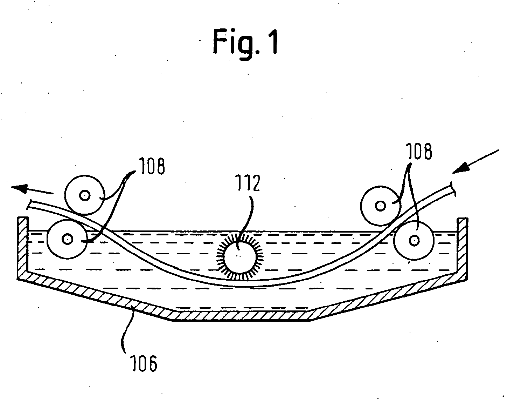

Fig. 1 is a schematic view of a developing equipment.

### Detailed Description of the Invention

### [Planographic printing method]

The planographic printing method of the invention is characterized in contacting a lithographic printing plate precursor, after the imagewise exposure, with an aqueous solution containing a hydrophobic organic compound and a water-soluble polymer compound, and then executing a printing operation by supplying a printing ink and a fountain solution. In the following, such aqueous solution is also called a processing solution.

The hydrophobic organic compound employed in the processing solution of the invention means a compound having a solubility in water of 10 mass% or less at a normal temperature (20°C). Such compound has a property of penetrating into an unexposed image recording layer. In the following examples of such hydrophobic organic compound will be shown, but the invention is not limited to such examples.

Examples include a carboxylate ester such as ethyl acetate, propyl acetate, butyl acetate, amyl acetate, benzyl acetate, ethylene glycol monobutyl acetate, butyl lactate, or butyl levulinate; a ketone such as ethyl butyl ketone, methyl isobutyl ketone, or cyclohexanone; an alcohol such as ethylene glycol monobutyl ether, ethylene glycol monobenzyl ether, ethylene glycol monophenyl ether, benzyl alcohol, methylphenylcarbinol, n-amyl alcohol or methylamyl alcohol; an alkyl-substituted aromatic hydrocarbon such as xylene; a halogenated hydrocarbon such as methylene dichloride, ethylene dichloride or monochlorobenzene; and an amine such as N-phenylethanolamine or N-phenyldiethanolamin. Such hydrophobic compound may be employed singly or in a combination of two or more kinds. Among these, ethylene glycol monophenyl ether, benzyl alcohol, N-phenylethanolamine or N-phenyldiethanolamine is particularly effective.

A content of the hydrophobic organic compound in the processing solution is generally 0.1 to 10 mass%, particularly preferably 0.5 to 5 mass%.

The water-soluble polymer compound to be employed in the processing solution of the invention can be, for example, a soybean polysaccharide, denatured starch, gum Arabic, dextrin, a cellulose derivative (such as carboxymethyl cellulose, carboxyethyl cellulose, or methyl cellulose) or a denatured substance thereof, pullulan, polyvinyl alcohol or a derivative thereof, polyvinylpyrrolidone, polyacrylamide or an acrylamide copolymer, a vinyl methyl ether/maleic anhydride copolymer, a vinyl acetate/maleic anhydride copolymer, or a styrene/maleic anhydride copolymer.

The soybean polysaccharide can be those already known, including a commercial product such as Soyafibe (manufactured by Fuji Seiyu Co.), and various grades can be employed. Preferred one has a viscosity of a 10 mass% aqueous solution within a range of 10- 100 mPa/sec.

The denatured starch is preferably that represented by a general formula (I). The starch represented by the general formula (I) can be that of corn, potato, tapioca, rice, wheat and the like. The denaturing of such starch can be achieved for example by a method of executing a decomposition with an acid or an enzyme within a range of 5 to 30 glucose residues per molecule, and adding oxypropylene in an alkali. 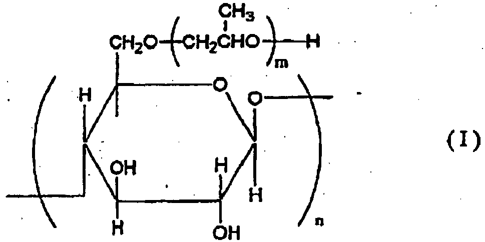 (in the formula, a degree of etherification (degree of substitution) is within a range or 0.05 - 1.2 per glucose unit; n represents an integer of 3 - 30; and m represents an integer of 1 - 3.)

Among the aforementioned water-soluble polymer compounds, particularly preferred ones include soybean polysaccharide, denatured starch, gum Arabic, dextrin, carboxymethyl cellulose and polyvinyl alcohol.

The water-soluble polymer compound may also be employed in a combination of two or more kinds. A content of the water-soluble polymer compound in the processing solution is preferably 0.1 to 20 mass%, more preferably 0.5 to 10 mass%.

The processing solution of the invention may further contain, in addition to the foregoing, a surfactant, a moistening agent, an antiseptic, a chelate compound, a defoaming agent, an organic acid, an inorganic acid or an inorganic salt.

The surfactant can be, for example, an anionic surfactant and/or a nonionic surfactant. As the anionic surfactant, there can be employed a fatty acid salt, an abietate salt, a hydroxyalkanesulfonate salt, an alkanesulfonate salt, a dialkylsulfosuccinate salt, a linear alkylbenzenesulfonate salt, a branched alkylbenzenesulfonate salt, an alkylnaphthalenesulfonate salt, an alkylphenoxypolyoxyethylene propylsulfonate salt, a polyoxyethylene alkylsulfophenyl ether salt, an N-methyl-N-oleyltaulin sodium salt, an N-alkylsulfosuccinic monoamide disodium salt, a petroleum sulfonate salt, sulfonated castor oil, sulfonated tallow oil, a sulfate ester salt of a fatty acid alkyl ester, an alkylsulfate ester salt, a polyoxyethylene alkyl ether sulfate ester salt, a fatty acid monoglyceride sulfate ester salt, a polyoxyethylene alkylphenyl ether sulfate ester salt, a polyoxyethylene styryl phenyl ether sulfate ester salt, an alkylphosphate ester salt, a polyoxyethylene alkyl ether phosphate ester salt, a polyoxyethylene alkylphenyl ether phosphate ester salt, a partial saponified product of a styrene-maleic anhydride copolymer, a partial saponified product of an olefin-maleic anhydride copolymer, or a naphthalenesulfonate salt-formalin condensate. Among these, a dialkylsulfosuccinate salt, an alkylsulfate ester salt or an alkylnaphthalenesulfonate salt is particularly preferably employed.

Also as the nonionic surfactant, there can be employed a polyoxyethylene alkyl ether, a polyoxyethylene alkylphenyl ether, a polyoxyethylene polystyrylphenylether, a glycerin-fatty acid partial ester, a sorbitan-fatty acid partial ester, a pentaerythritol-fatty acid partial ester, a propylene glycol-fatty acid monoester, a glucose-fatty acid partial ester, a polyoxyethylenesorbitan-fatty acid partial ester, a polyoxyethylenesorbitol-fatty acid partial ester, a polyethylene glycol-fatty acid ester, a polyglycerin-fatty acid partial ester, a polyoxyethyleneglycerin-fatty acid partial ester, a polyoxyethylene diglycerin, a fatty acid diethanolamine, an N,N-bis-2-hydroxyalkylamine, a polyoxyethylene alkylamine, a triethanolamine-fatty acid ester, or a trialkylamino oxide. Among these, a polyoxyethylene alkylphenyl ether, or a polyoxyethylene-polyoxypropylene block copolymer is preferably employed. Also an oxyethylene addition product of an acetylene glycol or an acetylene alcohol, a fluorine- or silicon-based anionic or nonionic surfactant can be similarly employed. Such surfactant may be employed in a combination of two or more kinds. It is preferred, for example, to employ a combination of two or more mutually different anionic surfactants, or a combination of an anionic surfactant and a nonionic surfactant. An amount of such surfactant is not particularly restricted, but is preferably 0.01 to 20 mass% with respect to the total mass of the processing solution.

As the moistening agent, there is advantageously employed ethylene glycol, propylene glycol, triethylene glycol, butylenes glycol, hexylene glycol, diethylene glycol, dipropylene glycol, glycerin, trimethylolpropane, or diglycerin. Such moistening agent may be employed singly or in a combination of two or more kinds. Such moistening agent is generally employed in an amount of 0.1 to 5 mass% with respect to the total mass of the processing solution.

As the antiseptic, there can be advantageously employed phenol or a derivative thereof, formalin, an imidazole derivative, sodium dehydroacetate, a 4-isothiazolin-3-one derivative, benzisothiazolin-3-one, a benzotriazole derivative, an amidinguanidine derivative, a quaternary ammonium salt, a derivative of pyridine, quinoline or guanidine, a derivative of diazine or triazole, a derivative of oxazole or oxazine, a nitrobromo alcohol such as 2-bromo-2-nitropropane-1,3-diol, 1,1-dibromo-1-nitro-2-ethanol or 1,1-dibromo-1-nitro-2-propanol. A preferred amount of addition is an amount stably effective to bacteria, molds and yeasts and dependent on the type thereof, but is preferably within a range of 0.01 to 4 mass% with respect to the processing solution at use, and two or more antiseptics are preferably employed in a combination, so as to be effective to various molds and bacteria.

The chelate compound can be, for example, an organic phosphonic acid or a phophonoalkaline tricarboxylic acid such as ethylenediamine tetraacetic acid, a potassium salt or a sodium salt thereof; diethylenetriamine pentaacetic acid, a potassium salt or a sodium salt thereof; triethylenetetramine hexaacetic acid, a potassium salt or a sodium salt thereof; hydroxyethylethylene triacetic acid, a potassium salt or a sodium salt thereof; nitrilotriacetic acid, a potassium salt or a sodium salt thereof; 1-hydroxyethane-1,1-diphosphonic acid, a potassium salt or a sodium salt thereof; aminotri(methylenephosphonic acid), a potassium salt or a sodium salt thereof. Also instead of the sodium salt or the potassium salt, an organic amine salt of the aforementioned chelate compound is also effective. Such chelate compound is so selected as to stably present in the processing solution and not to disturb the printing property. An amount of addition is 0.001 to 1.0 mass% with respect to the processing solution at the use.

The defoaming agent can be an ordinary silicone-based defoamer of self-emulsifying type or emulsion type, or a nonionic surfactant with an HLB value of 5 or less, and a silicone-based defoaming agent is preferred.

In such defoaming agent, an emulsified dispersion type or a solubilized type can be employed. An amoung of the defoaming agent is optimally within a range of 0.001 to 1.0 mass% with respect to the processing solution at use.

The organic acid can be citric acid, acetic acid, oxalic acid, malonic acid, salicylic acid, capric acid, tartaric acid, malic acid, lactic acid, levulinic acid, p-toluenesulfonic acid, xylenesulfonic acid, phytic acid or an organic phosphonic acid. The organic acid may be employed as an alkali metal salt or an ammonium salt thereof. An amount of the organic acid is 0.01 to 0.5 mass% with respect to the total mass of the processing solution.

The inorganic acid or inorganic salt can be, for example, phosphoric acid, metaphosphoric acid, ammonium dihydrogenphosphate, ammonium hydrogenphosphate, sodium dihydrogenphosphate, sodium hydrogenphosphate, potassium dihydrogenphosphate, potassium hydrogenphosphate, sodium tripolyphosphate, potassium pyrophosphate, sodium hexametaphosphate, magnesium nitrate, sodium nitrate, potassium nitrate, ammonium nitrate, sodium sulfate, potassium sulfate, ammonium sulfate, sodium sulfite, ammonium sulfite, sodium hydrogensulfate, or nickel sulfate. An amount of the inorganic salt is selected as 0.01 to 0.5 mass% with respect to the total mass of the processing solution.

The processing solution of the invention can be obtained by dissolving or dispersing the aforementioned necessary components in water. A solid content of the processing solution is preferably 1 to 20 mass%. It is also possible to prepare a concentrated solution and dilute it with water at the use.

As a method for contacting the lithographic printing plate precursor of the invention with the processing solution, there can be employed a manual process, a dip process of a mechanical process, as in the platemaking method as described above.

By the aforementioned contact of the lithographic printing plate precursor after the imagewise exposure and the processing solution, a surface of the image area shows an increased oleophilicity to improve the inking property, and the hydrophilic component penetrates in the image recording layer of an unexposed area thereby improving the developing property.

Note that, the image recording layer of the unexposed area may be removed, or may not be removed when contacting with the processing solution.

Prior to the developing process described above, the lithographic printing plate precursor is subjected to an exposure through a transparent original having a line image or a screened halftone image or an imagewise exposure with a laser beam scanning based on digital data. A light source suitable for the exposure can be same as those described for the platemaking method, but is particularly preferably a laser beam, for example from a solid-state or semiconductor laser emitting an infrared light of 760 - 1200 nm, an ultraviolet semiconductor laser emitting a light of 250 - 420 nm, an argon ion laser emitting a visible light, or an FD-YAG laser. For facilitating the platemaking operation, there is preferred a laser emitting an infrared light or an ultraviolet light, enabling the operation under a white or yellow lamp.

In the invention, the lithographic printing plate precursor subjected to the aforementioned process with the processing solution is preferably dried for facilitating a handling thereafter. The drying can be achieved for example by a spontaneous drying by standing indoors, a drying with hot air, or a drying with a dryer attached to a gum coater or an automatic developing apparatus.

The dried lithographic printing plate precursor is mounted on a printing press, and is subjected to a printing operation by a supply of a printing ink and a fountain solution. In a printing operation by supplying the lithographic printing plate precursor, subjected to the exposure and the aforementioned process, with the printing ink and the fountain solution, in an unexposed area, the image recording layer of such unexposed area remaining even after the processing with the processing solution is dissolved and/or dispersed by the printing ink and/or the fountain solution and completely removed, thereby exposing a surface of the hydrophilic substrate. On the other hand, in an exposed area, the polymerized and cured image recording layer remains to constitute a printing ink receiving portion (image area) having an oleophilic surface. As a result, the fountain solution adheres to thus exposed hydrophilic surface, while the printing ink adheres to the image recording layer of the exposed area, whereby a printing operation is initiated. In this operation, the fountain solution or the printing ink may be supplied first to the plate surface.

In this manner, the lithographic printing plate precursor is developed on the offset printing press and is directly used for making a plurality of prints.

### [Image recording layer]

A lithographic printing plate precursor employed in a platemaking method has a negative image recording layer containing a water-insoluble polymer. For realizing an ease of development and a satisfactory run length, the negative image recording layer is preferably a radical polymerizable image recording layer containing further a polymerization initiator and a polymerizable compound.

### <Water-insoluble polymer>

The image recording layer utilizes a water-insoluble polymer as a binder polymer. The water-insoluble polymer is preferably substantially free from an acid group such as a carboxyl group, a sulfon group or a phosphoric acid group. Such water-insoluble polymer improves a film strength, a water resistance and an inking property of the image recording layer, thereby improving a run length. Also the water-insoluble polymer preferably has a glass transition temperature (Tg) of 5 to 85°C. A satisfactory developing property can be obtained by employing an aqueous solution of a temperature higher than the glass transition temperature of the water-insoluble polymer, as the developing solution.

As the water-insoluble polymer, already known ones can be employed without restriction as long as an acid group is substantially absent and the glass transition temperature (Tg) is within the aforementioned range, but a linear organic polymer having a film forming property is preferred.

Such water-insoluble polymer is preferably selected, for example, from acrylic resin, polyvinylacetal resin, polyurethane resin, polyamide resin, epoxy resin, methacrylic resin, styrenic resin and polyester resin. Among these, acrylic resin is preferred, and a (meth)acrylate ester copolymer is particularly preferred. More specifically, there is particularly preferred a copolymer of an alkyl or aralkyl (meth)acrylate ester and a (meth)acrylate ester containing a -CH₂CH₂O- unit or a -CH₂CH₂NH- unit in R or an ester residue (-COOR) thereof. A preferred alkyl group in the alkyl (meth)acrylate ester is an alkyl group with 1 to 5 carbon atoms, more preferably a methyl group. A preferred alkyl (meth)acrylate ester is benzyl (meth)acrylate.

Also the water-insoluble polymer may have a crosslinking property in order to improve the film strength of the image area. For providing the water-insoluble polymer with a crosslinking property, a crosslinkable functional group such as an ethylenic unsaturated bond may be introduced into the polymer. The crosslinkable functional group may be introduced by a copolymerization. As an example of the water-insoluble polymer with an ethylenic unsaturated bond in the molecule, there can be employed a polymer of an ester or an amide of acrylic acid or methacrylic acid in which a residue of ester or amide (R' of -COOR' or -CONHR') has an ethylenic unsaturated bond.

Examples of the residue having the ethylenic unsaturated bond (aforementioned R') include -(CH₂)ₙCR¹=CR²R³, -(CH₂O)ₙCH₂CR¹=CR²R³, -(CH₂CH₂O)ₙCH₂CR¹=CR²R³, - (CH₂)ₙNH-CO-O-CH₂CR¹=CR²R³, -(CH₂)ₙ-O-CO-CR¹=CR²R³, and -(CH₂CH₂O)₂-X (wherein R¹ - R³ each independently represents a hydrogen atom, a halogen atom, or an alkyl group, an aryl group, an alkoxy group or an aryloxy group with 1 to 20 carbon atoms, in which R¹ and R² or R³ may be mutually bonded to form a ring; n represents an integer of 1 - 10; and X represents a dicyclopentadienyl residue).

Specific examples of the ester residue include -CH₂CH=CH₂ (described in JP-B No. 7-21633), -CH₂CH₂O-CH₂CH=CH₂, -CH₂C(CH₂)=CH₂, -CH₂CH=CH-C₆H₅, CH₂CH₂OCOCH=CH-C₆H₅, -CH₂CH₂-NHCOO-CH₂CH=CH₂, and -CH₂CH₂O-X (wherein X represents a dicyclopentadienyl residue).

Specific examples of the amide residue include -CH₂CH=CH₂, -CH₂CH₂-Y (wherein Y represents a cyclohexene residue), and -CH₂CH₂-OCO-CH=CH₂.

The water-insoluble polymer having a crosslinking property is cured, for example, by an addition of a free radical (a polymerization initiating radical or a growing radical in the polymerization process of the polymerizable compound) to cause an addition polymerization directly between the polymers or via a polymerization chain of the polymerizable compound) thereby forming a crosslinking between the polymer molecules. Otherwise a curing is achieved by an extraction of an atom in the polymer (for example a hydrogen atom on a carbon atom adjacent to the crosslinking functional group) to form a polymer radical, which is mutually bonded thereby forming a crosslinking between the polymer molecules.

A content of the crosslinkable group in the water-insoluble polymer (a content of a radical polymerizable unsaturated double bond by an iodine titration) is preferably 0.1 to 10.0 mmol per 1 g of the water-insoluble polymer, more preferably 1.0 to 7.0 mmol and most preferably 2.0 to 5.5 mmol.

Also the binder polymer is preferably hydrophilic from the standpoint of improving the developing property with an aqueous solution, and, from the standpoint of improving the length of run, the binder polymer is required to have a satisfactory mutual solubility with the polymerizable compound contained in the image recording layer, namely preferably being oleophilic. Based on these standpoints, it is also effective, for improving the developing property and the run length, to copolymerize a hydrophilic group and an oleophilic group in the water-insoluble polymer. The hydrophilic group can advantageously be, for example, a hydroxyl group, a hydroxyethyl group, an ethylenoxy group, a hydroxypropyl group, a polyoxyethyl group, a polyoxypropyl group, an amino group, an aminoethyl group, an aminopropyl group, an ammonium group or an amide group.

The water-insoluble polymer has a mass-average molecular weight preferably of 5,000 or higher, more preferably 10,000 to 300,000, and a number-average molecular weight preferably of 1,000 or higher, more preferably 2,000 to 250,000. A dispersion degree (mass-average molecular weight/number-average molecular weight) is preferably 1.1 to 10.

The water-insoluble polymer may be a random polymer, a block polymer, or a graft polymer, and is preferably a random polymer.

The water-insoluble polymer may be employed singly or in a mixture of two or more kinds.

A content of the water-insoluble polymer is 5 to 90 mass% with respect to the total solid of the image recording layer, preferably 10 to 70 mass%, and more preferably 10 to 60 mass%. The strength in the image area and the image forming property become satisfactory in such range.

### <Polymerization initiator>

The polymerization initiator is a compound capable of generating a radical by optical or thermal energy, thereby initiating or accelerating a polymerization of a compound having a polymerizable unsaturated group. Such radical generating agent can be suitably selected from a known polymerization initiator and a compound having a bond of a low dissociation energy.

The aforementioned radical-generating compound can be, for example, an organic halogen compound, a carbonyl compound, an organic peroxide, an azo polymerization initiator, an azide compound, a metallocene compound, a hexaarylbiimidazole compound, an organic boron compound, a disulfone compound, an oxime ester compound or an onium salt compound.

Specific examples of the organic halogen compound include those described in Wakabayashi et al., Bull. Chem. Soc. Japan, 42, 2924(1969), USP No. 3,905,815, JP-B No. 46-4605, JP-A Nos. 48-36281, 53-133428, 55-32070, 60-239736, 61-169835, 61-169837, 62-58241, 62-212401, 63-70243 and 63-298339, and M. P. Hutt, Journal of Heterocyclic Chemistry, 1 (No. 3)(1970). Among these, an oxazole compound and an S-triazine compound, substituted with a trihalomethyl group, are preferred.

There is more preferred an s-triazine derivative or an oxadiazole derivative in which at least a mon-, di- or trihalogen-substituted methyl group is bonded to an s-triazine ring or an oxadiazole ring. Specific examples include 2,4,6-tris(monochloromethyl)-s-triazine, 2,4,6-tris(dichloromethyl)-s-triazine, 2,4,6-tris(trichloromethyl)-s-triazine, 2-methyl-4,6-bis(trichloromethyl)-s-triazine, 2-n-propyl-4,6-bis(trichloromethyl)-s-triazine, 2-(α,α,β-trichloroethyl)-4,6-bis(trichloromethyl)-s-triazine, 2-(3,4-epoxyphenyl)-4,6-bis(trichloromethyl)-s-triazine, 2-[1-(p-methoxyphenyl)-2,4-butadienyl]-4,6-bis(trichloromethyl)-s-triazine, 2-styryl-4,6-bis(trichloromethyl)-s-triazine, 2-(p-methoxystyryl)-4,6-bis(trichloromethyl)-s-triazine, 2-(p-I-propyloxystyryl)-4,6-bis(trichloromethyl)-s-triazine, 2-(p-tolyl)-4,6-bis(trichloromethyl)-s-triazine, 2-(4-methoxynaphthyl)-4,6-bis(trichloromethyl)-s-triazine, 2-phenylthio-4,6-bis(trichloromethyl)-s-triazine, 2-benzylthio-4,6-bis(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine, and following compounds:

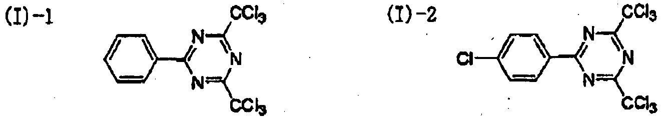

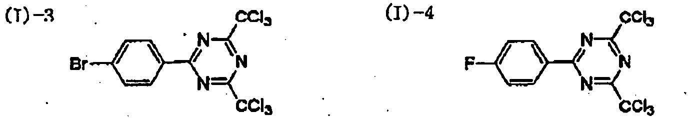

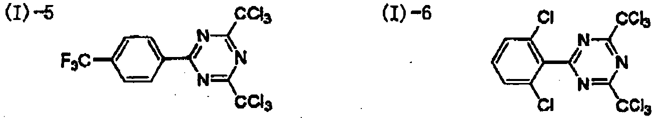

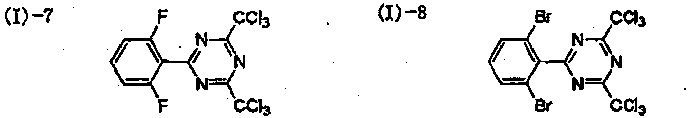

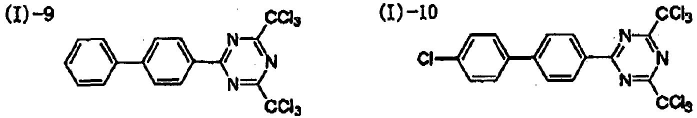

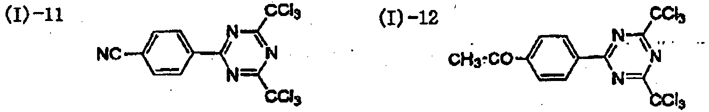

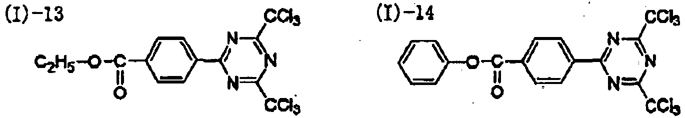

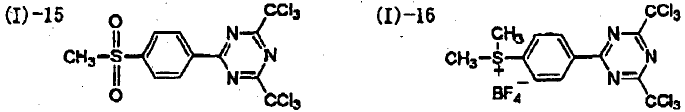

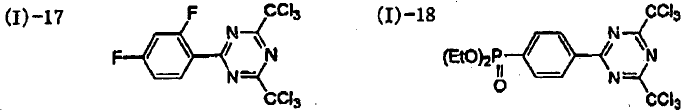

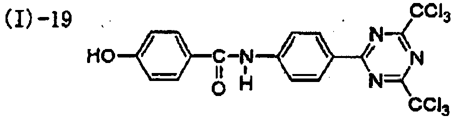

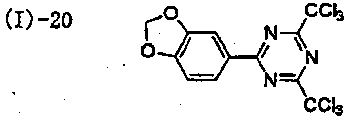

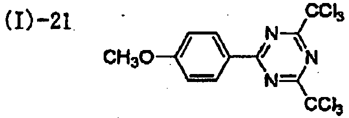

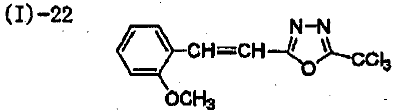

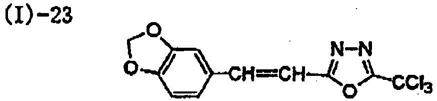

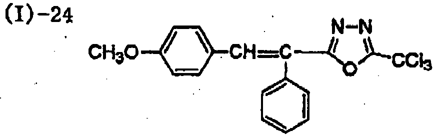

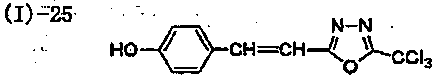

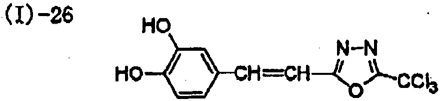

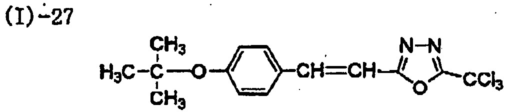

Examples of the carbonyl compound include a benzophenone derivative such as benzophenone, Michler's ketone, 2-methylbenzophenone, 3-methylbenzophenone, 4-methylbenzophenone, 2-chlorobenzophenone, 4-bromobenzophenone, or 2-carboxybenzophenone; an acetophenone derivative such as 2,2-dimethoxy-2-phenylacetophenone, 2,2-diethoxyacetophenone, 1-hydroxycyclohexyl phenyl ketone, α-hydroxy-2-methylphenylpropanone, 1-hydroxy-1-methylethyl-(p-isopropylphenyl) ketone, 1-hydroxy-1-(p-dodecylphenyl) ketone, 2-methyl-(4'-(methylthio)phenyl)-2-morpholino-1-propanone, or 1,1,1-trichloromethyl-(p-butylphenyl) ketone; a thioxanthone derivative such as thioxanthone, 2-ethylthioxanthone, 2-isopropylthioxanthone, 2-chlorothioxanthone, 2,4-dimethylthioxanthone, 2,4-diethylthioxanthone, or 2,4-diisopropylthioxanthone; and a benzoate ester derivative such as ethyl p-dimethylaminobenzoate or ethyl p-diethylaminobenzoate.

Examples of the azo compound include those described in JP-A No. 8-108621.

Examples of the organic peroxide include trimethylcyclohexanone peroxide, acetylacetone peroxide, 1,1-bis(tert-butylperoxy)-3,3,5-trimethylcyclohexanone, 1,1-bis(tert-butylperoxy)-cyclohexane, 2,2-bis(tert-butylperoxy)-butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butylcumyl peroxide, dicumyl peroxide, 2,5-dimethyl-2,5-di(tert-butylperoxy)hexane, 2,5-oxanoyl peroxide, succinoyl peroxide, benzoyl peroxide, 2,4-dichlorobenzoyl peroxide, diisopropyl peroxydicarbonate, di-2-ethylhexyl peroxydicarbonate, di-2-ethoxyethyl peroxydicarbonate, dimethoxyisopropyl peroxycarbonate, di(3-methyl-3-methoxybutyl) peroxydicarbonate, tert-butyl peroxyacetate, tert-butyl peroxypivalate, tert-butyl peroxy neodecanoate, tert-butyl peroxyoctanoate, tert-butyl peroxylaurate, tosyl carbonate, 3,3',4,4'-tetra-(t-butylperoxycarbonyl)benzophenone, 3,3',4,4'-tetra-(t-hexylperoxycarbonyl)benzophenone, 3,3',4,4'-tetra-(p-isopropylcumylperoxycarbonyl)benzophenone, carbonyldi(t-butylperoxy dihydrogen diphthalate) and carbonyldi(t-hexylperoxy dihydrogen diphthalate).

Examples of the metallocene compound include various titanocene compounds described in JP-A Nos. 59-152396, 61-151197, 63-41484, 2-249, 2-4705, and 5-83588, such as di-cyclopentadienyl-Ti-bisphenyl, di-cyclopentadienyl-Ti-bis-2,6-difluorophen-1-yl, di-cyclopentadienyl-Ti-bis-2,4-difluorophen-1-yl, di-cyclopentadienyl-Ti-bis-2,4,6-trifluorophen-1-yl, di-cyclopentadienyl-Ti-bis-2,3,5,6-tetrafluorophen-1-yl, dicyclopentadienyl-Ti-bis-2,3,4,5,6-pentafluorophen-1-yl, di-methylcyclopentadienyl-Ti-bis-2,6-difluorophen-1-yl, di-methylcyclopentadienyl-Ti-bis-2,4,6-trifluorophen-1-yl, dimetylcyclopentadienyl-Ti-bis-2,3,5,6-tetrafluorophen-1-yl, di-methylcyclopentadienyl-Ti-bis-2,3,4,5,6-pentafluorophen-1-yl, and an iron-allene.complex described in JP-A Nos. 1-304453 and 1-152109.

Examples of the hexaarylbiimidazole compound include various compounds described in JP-B No. 6-29285 and USP Nos. 3,479,185, 4,311,783 and 4,622,286, specifically such as 2,2'-bis(o-chlorophenyl)-4,4',5,3'-tetraphenylbiimidazole, 2,2'-bis(o-bromophenyl)-4,4',5,5'-tetraphenylbiimadazole, 2,2'-bis(o,p-dichloropheynyl)-4,4',5,5'-tetraphenylbiimidazole, 2,2'-bis(o-chlorophenyl)-4,4',5,5'-tetra(m-methoxyphenyl)-biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, and 2,2'-bis(o-trifluorophenyl)-4,4',5,5'-tetraphenylbiimidazole.

Examples of the organic boron compound include an organic borate salt described in JP-A Nos. 62-143044, 62-150242, 9-188685, 9-188686, 9-188710, 2000-131837, and 2002-107916, Japanese Patent No. 2764769, JP-A No. 2002-116539, and Kunz and Martin, "Rad. Tech. 98, Proceeding April 19-22, 1998, Chicago", an organic boron sulfonium complex or an organic boron oxosulfonium complex described in JP-A Nos. 6-1576232, 6-175564 and 6-175561, an organic boron iodonium complex described in JP-A Nos. 6-175554 and 6-175553, an organic boron phosphonium complex described in JP-A No. 9-188710, and an organic boron transition metal-coordinated complex described in JP-A Nos. 6-348011, 7-128785, 7-140589, 7-306527 and 7-292014.

Examples of the disulfone compound include compounds described in JP-A Nos. 61-166544 and 2003-328465.

Examples of the oxime ester compound include compounds described in J. C. S. Perkin II (1979) 1653-1660, J. C. S. Perkin II (1979) 156-162, Journal of Photopolymer Science and Technology (1995) 202 - 232, and JP-A No. 2000-66385, and those described in JP-A No. 2000-80068 and specifically include compounds represented by following structural formulas and compound described in examples.

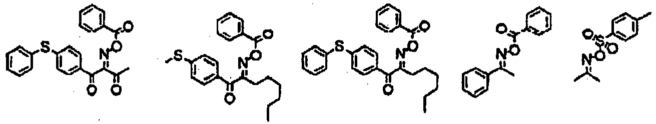

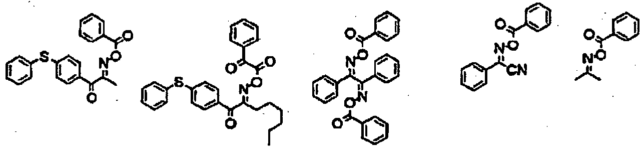

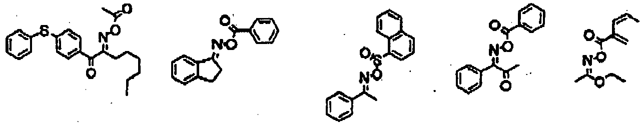

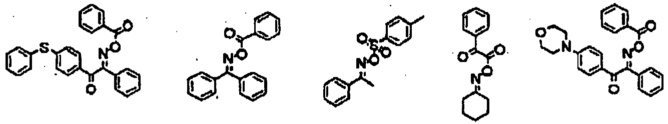

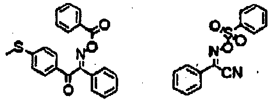

Examples of the onium salt compound include diazonium salts described by S. I. Schlesinger, Photogr. Sci. Eng., 18, 387(1974), and T. S. Bal et al., Polymer, 21, 423(1980); ammonium salts described in USP Nos. 4,069,055 and JP-A No. 4-365049; phosphonium salts described in USP Nos. 4,069,055 and 4,069,056; iodonium salts described in European Patent No. 104,143, USP Nos. 339,049 and 410,201, JP-A Nos. 2-150848 and 2-296514; sulfonium salts described in European Patents Nos. 370,693, 390,214, 233,567, 297,443 and 297,442, USP Nos. 4,933,377, 161,811, 410,201, 339,049, 4,760,013, 4,734,444 and 2,833,827, German patents Nos. 2,904,626, 3,604,580 and 3,604,581; selenonium salts described by J. V. Crivello et al., Macromolecules, 10(6), 1307(1977), J. V. Crivello et al., J. Polymer Sci., Polymer Chem. Ed., 17, 1047(1979); and arsonium salts described by C. S. Wen et al., The. Proc. Conf. Rad. Curing ASIA, p478 Tokyo, Oct(1988).

In the invention, such onium salt function not as an acid generating agent but as an ionic radical polymerization initiator.

Au onium salt advantageously employed in the invention is represented by following general formulas (RI-I) - (RI-III).

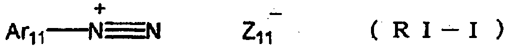

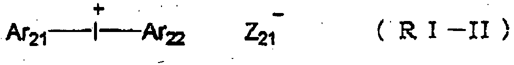

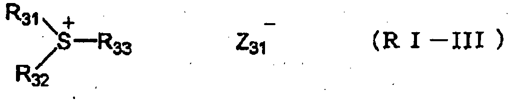

In the formula (RI-I), Ar₁₁ represents an aryl group with 20 carbon atoms or less which may have 1 - 6 substituents, and preferred examples of the substituent include an alkyl group with 1 - 12 carbon atoms, an alkenyl group with 1 - 12 carbon atoms, an alkinyl group with 1 - 12 carbon atoms, an aryl group with 1 - 12 carbon atoms, an alkoxy group with 1 - 12 carbon atoms, an aryloxy group with 1 - 12 carbon atoms, a halogen atom, an alkylamino group with 1 - 12 carbon atoms, a dialkylamino group with 1 - 12 carbon atoms, an alkylamide or arylamide group with 1 - 12 carbon atoms, a carbonyl group, a carboxyl group, a cyano group, a sulfonyl group, a thioalkyl group with 1 - 12 carbon atoms, and a thioaryl group with 1 - 12 carbon atoms. Z₁₁ represents a monovalent anion, and specifically a halogen ion, a perchlorate ion, a hexafluorophosphate ion, a tetrafluoroborate ion, a sulfonate ion, a sulfinate ion, a thiosulfonate ion or a sulfate ion. Among these a perchlorate ion, a hexafluorophosphate ion, tetrafluoroborate ion, a sulfonate ion or a sulfinate ion is preferred in consideration of the stability.

In the formula (RI-II), Ar₂₁ and Ar₂₂ each independently represents an aryl group with 20 carbon atoms or less which may have 1 - 6 substituents, and preferred examples of the substituent include an alkyl group with 1 - 12 carbon atoms, an alkenyl group with 1 - 12 carbon atoms, an alkinyl group with 1 - 12 carbon atoms, an aryl group with 1 - 12 carbon atoms, an alkoxy group with 1 - 12 carbon atoms, an aryloxy group with 1 - 12 carbon atoms, a halogen atom, an alkylamino group with 1 - 12 carbon atoms, a dialkylamino group with 1 - 12 carbon atoms, an alkylamide or arylamide group with 1 - 12 carbon atoms, a carbonyl group, a carboxyl group, a cyano group, a sulfonyl group, a thioalkyl group with 1 - 12 carbon atoms, and a thioaryl group with 1 - 12 carbon atoms. Z₂₁⁻ represents a monovalent anion, and specifically a halogen ion, a perchlorate ion, a hexafluorophosphate ion, a tetrafluoroborate ion, a sulfonate ion, a sulfinate ion, a thiosulfonate ion or a sulfate ion. Among these a perchlorate ion, a hexafluorophosphate ion, tetrafluoroborate ion, a sulfonate ion, a sulfinate ion or a carboxylate ion is preferred in consideration of stability and reactivity.

In the formula (RI-III), R₃₁, R₃₂ and R₃₃ each independently represents an aryl group, an alkyl group, an alkenyl group or an alkinyl group, which has 20 carbon atoms or less and which may have 1 - 6 substituents. Among these, an aryl group is preferred in consideration of reactivity and stability. Preferred examples of the substituent include an alkyl group with 1 - 12 carbon atoms, an alkenyl group with 1 - 12 carbon atoms, an alkinyl group with 1 - 12 carbon atoms, an aryl group with 1 - 12 carbon atoms, an alkoxy group with 1 - 12 carbon atoms, an aryloxy group with 1 - 12 carbon atoms, a halogen atom, an alkylamino group with 1 - 12 carbon atoms, a dialkylamino group with 1 - 12 carbon atoms, an alkylamide or arylamide group with 1 - 12 carbon atoms, a carbonyl group, a carboxyl group, a cyano group, a sulfonyl group, a thioalkyl group with 1 - 12 carbon atoms, and a thioaryl group with 1 - 12 carbon atoms. Z₃₁ represents a monovalent anion, and specifically a halogen ion, a perchlorate ion, a hexafluorophosphate ion, a tetrafluoroborate ion, a sulfonate ion, a sulfinate ion, a thiosulfonate ion or a sulfate ion. Among these a perchlorate ion, a hexafluorophosphate ion, tetrafluoroborate ion, a sulfonate ion, a sulfinate ion or a carboxylate ion is preferred in consideration of stability and reactivity. A carboxylate ion described in JP-A No. 2001-343742 is more preferable, and a carboxylate ion described in JP-A No. 2002-148790 is particularly preferable.

In the following, there will be shown specific examples of the onium salt preferable in the invention, but such examples are not restrictive.

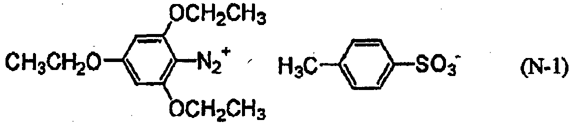

PF₆⁻ (N-2)

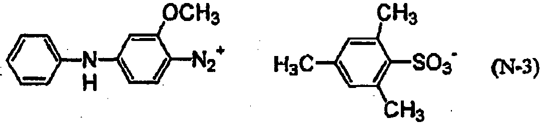

ClO₄⁻ (N-4)

PF₆⁻ (N-5)

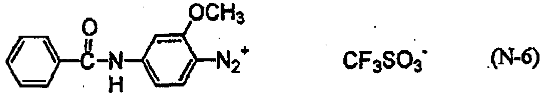

BF₄⁻ (N-7)

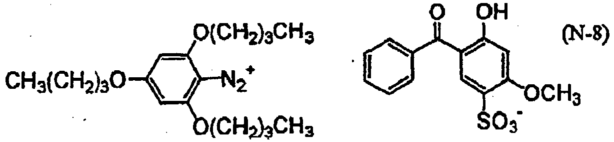

ClO₄⁻ (N-9)

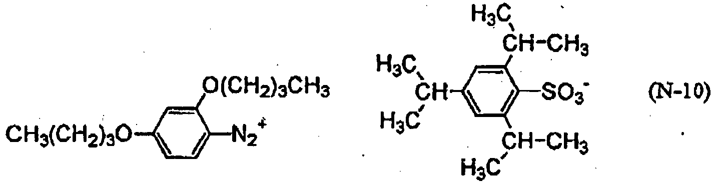

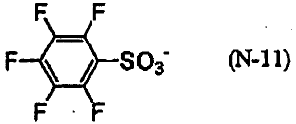

PF₆⁻ (N-12)

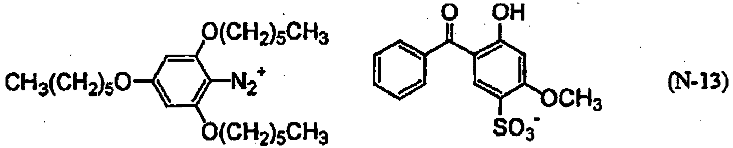

ClO₄⁻ (N-14)

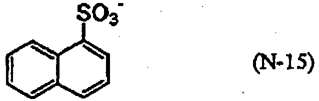

PF₆⁻ (N-16)

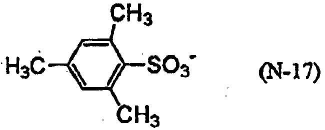

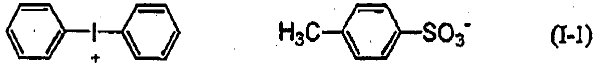

PF₆⁻ (I-2)

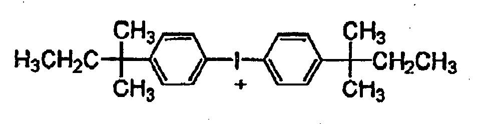

PF₆⁻ (I-3)

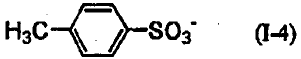

ClO₄⁻ (I-5)

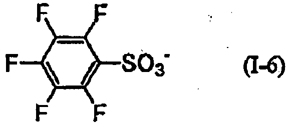

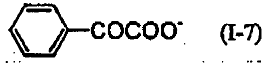

CF₃SO₃⁻ (I-8)

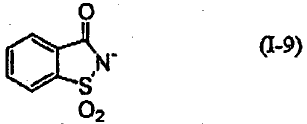

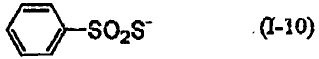

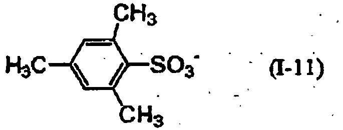

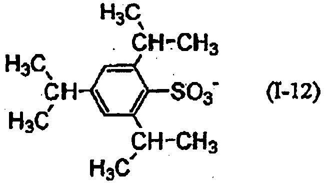

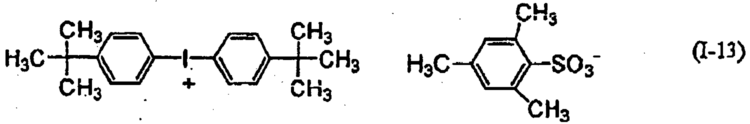

ClO₄⁻ (I-14)

PF₆⁻ (I-15)

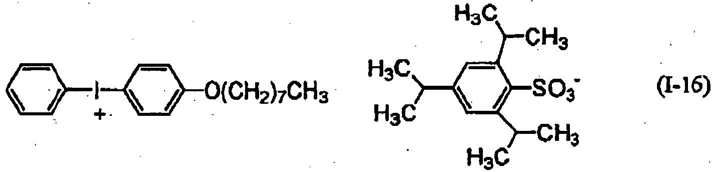

CF₃COO⁻ (I-17)

CF₃SO₃⁻ (I-18)

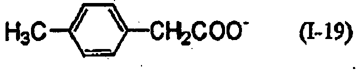

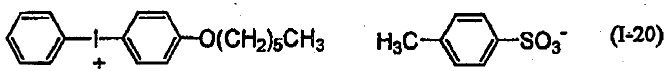

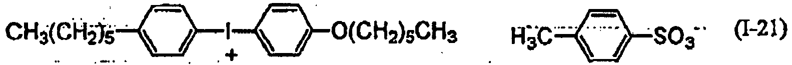

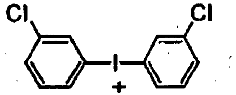

BF₄⁻ (I-22)

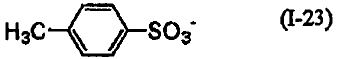

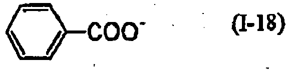

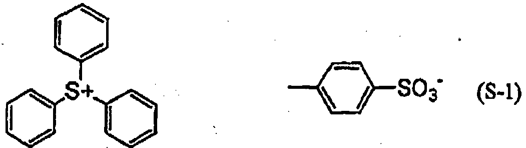

PF₆⁻ (S-2)

ClO₄⁻ (S-3)

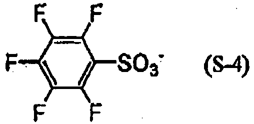

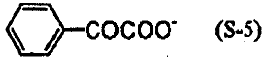

CF₃SO₃⁻ (S-6)

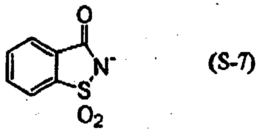

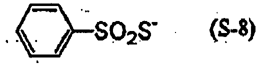

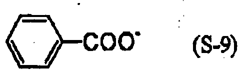

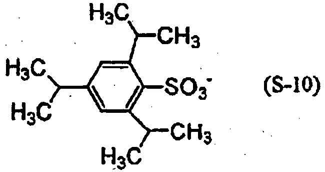

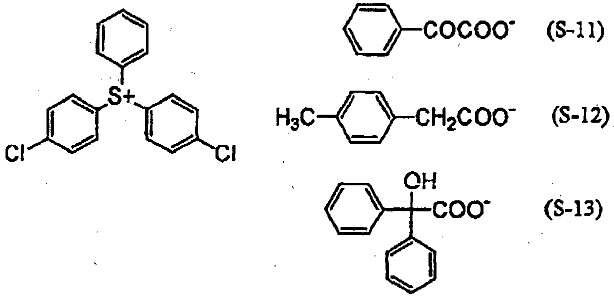

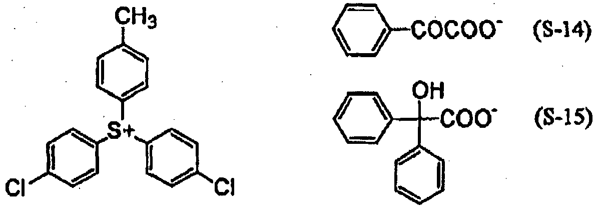

BF₄⁻ (S-16)

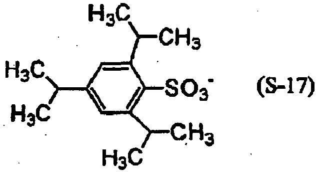

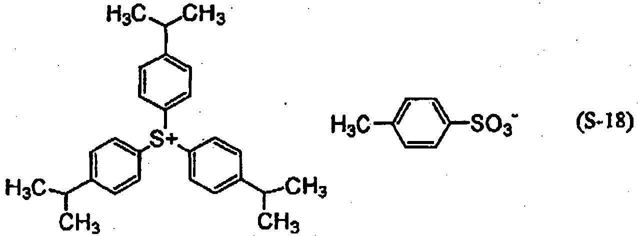

The polymerization initiator is not limited to the foregoing, but, in consideration reactivity and stability, is more preferably a triazine initiator, an organic halogen compound, an oxime ester compound, a diazonium salt, an iodonium salt or a sulfonium salt.

Such polymerization initiator may be employed singly or in a combination of two or more kinds. Also such polymerization initiator may be included in a same layer containing other components, or may be included in a separately provided layer. Such polymerization initiator is preferably added in an amount of 0.1 to 50 mass% with respect to the total solids constituting the image recording layer, more preferably 0.5 to 30 mass% and particularly preferably 0.8 - 20 mass%.

### <Polymerizable compound>

The polymerizable compound is an addition polymnerizable compound having at least an ethylenic unsaturated double bond, and is selected from compounds including at least one, preferably two or more, ethylenic unsaturated bonds. Such compounds are widely known in the related industrial field, and may be employed in the invention without any particular limitation.

Such compounds have a chemical structure of a monomer, a prepolymer namely a dimer, a trimer or an oligomer, or a mixture thereof or a copolymer thereof. Examples of such monomer and the copolymer thereof include an unsaturated carboxylic acid (such as acrylic acid, methacrylic acid, itaconic acid, crotonic acid, isocrotonic acid or maleic acid), an ester thereof and an amide thereof, and there is preferably employed an ester of an unsaturated carboxylic acid and an aliphatic polyhydric alcohol, or an amide of an unsaturated carboxylic acid and an aliphatic polyvalent amine. Also there can be advantageously employed an unsaturated carboxylic acid ester having a nucleophilic substituent such as a hydroxyl group, an amino group or a mercapto group, an addition product of an amide with a monofunctional or polyfunctional isocyanate or with an epoxy compound, or a dehydration condensation product with a monofunctional or polyfunctional carboxylic acid. Also there can be advantageously employed an unsaturated carboxylic acid ester having an electrophilic substituent such as an isocyanate group or an epoxy group, an addition product of an amide and a monohydric or polyhydric alcohol, an amine or a thiol, or a substitution reaction product of an unsaturated carboxylic acid ester or an amide having a cleavable substituent such as a halogen group or an acyloxy group with a monohydric or polyhydric alcohol, an amide or a thiol. As other examples, there can also be employed compounds in which the above-mentioned unsaturated carboxylic acid is replaced by an unsaturated phosphonic acid, styrene or vinyl ether.

Specific examples of an ester monomer of an aliphatic polyhydric alcohol and an unsaturated carboxylic acid include, within an acrylic acid ester, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropanel tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, a polyester acrylate oligomer, and isocyanuric acid EO-denatured triacrylate.

Also examples of a methacrylic acid ester include tetramethylene glycol dimethacrylate, triethylene glycol dimethacrylate, peopentyl glycol dimethacrylate, trimethylolpropane trimethacrylate, trimethylolethane trimethacrylate, ethylene glycol dimethacrylate, 1,3-butanediol dimethacrylate, hexandiol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethylmethane, and bis[p-(methacryloxyethoxy)phenyl]dimethylmethane.

Also examples of an itaconic acid ester include ethylene glycol diitaconate, propylene glycol diitaconate, 1,3-butanediol diitaconate, 1,4-butanediol diitaconate, tetramethylene glycol diitaconate, pentaerythritol diitaconate, and sorbitol tetraitaconate. Also example of a crotonic acid ester include ethylene glycol dicrotonate, tetramethylene glycol dicrotonate, pentaerythritol dicrotonate, and sorbitol tetracrotonate. Also example of an isocrotonic acid ester include ethylene glycol diisocrotonate, pentaerythritol diisocrotonate, and sorbitol tetraisocrotonate. Also example of a maleic acid ester include ethylene glycol dimaleate, triethylene glycol dimaleate, pentaerythritol dimaleate, and sorbitol tetramaleate.

Other examples of the ester include aliphatic alcohol esters described in JP-B Nos. 51-47334 and 57-196231, those having an aromatic skeleton described in JP-A Nos. 59-5240, 59-5241 and 2-226149, and those having an amino group described in JP-A No. 1-165613. Also the aforementioned ester monomer may also be employed as a mixture.

Also specific examples of the monomer constituted by an amide of an aliphatic polyvalent amine and an unsaturated carboxylic acid include methylenebis-acrylamide, methylenebis-methacrylamide, 1,6-hexamethylenebis-acrylamide, 1,6-hexamethylenebis-methacrylamide, diethylenetriamine trisacrylamide, xylilenebisacrylamide and xylilenebismethacrylamide. Examples of another preferred amide monomer include those having a cyclohexylene structure described in JP-B No. 54-21726.

Also there is advantageously employed an urethane addition polymerizable compound which is prepared by an addition reaction of an isocyanate and a hydroxyl group, and specific examples of such compound include a vinylurethane compound having two or more polymerizable vinyl groups in a molecule, and prepared by adding a vinyl monomer having a hydroxyl group and represented by a following general formula to a polyisocyanate compound having two or more isocyanate groups in a molecule, as described in JP-B No. 48-41708:

CH₂=C(R₄)COOCH₂CH(R₅)OH (A)

wherein R₄ and R₅ each represents H or CH₃.

Furthermore, there can be advantageously employed an urethane acrylate described in JP-A No. 51-37193, JP-B Nos. 2-32293 and 2-16765, and an urethane compound having an ethylene oxide structure described in JP-B Nos. 58-49860, 56-17654, 62-39417 and 62-39418. Furthermore, there may also be employed a radical polymerizable compound having an amino structure or a sulfide structure in a molecule, as described in JP-A Nos. 63-277653, 63.260909 and 1-105238, thereby providing a photopolymerizable composition of a very excellent photosensitivity.

Still other examples include a polyfunctional acrylate or methacrylate such as a polyester acrylate or an epoxy acrylate formed by reacting an epoxy resin and (meth)acrylic acid as described in JP-A No. 48-64183, JP-B Nos. 49-43191 and 52-30490. Still other examples include a specified unsaturated compound as described in JP-B Nos. 46-43946, 1-40337 and 1-40336, and a vinylphosphonic acid compound described in JP-A No. 2-25493. Also in certain cases, there is advantageously employed a structure including a perfluoroalkyl group described in JP-A No. 61-22048. Also there can be employed photocurable monomers and oligomers introduced in Nippon Secchaku Kyokai-Shi (Bulletin of Japanese Adhesive Society), vol. 20, No. 7, pp.300-308 (1984).

A compound having a vinyl ether group to be employed in the present invention can be those described in JP-A No. 2002-029162. Specific examples include tetramethylene glycol divinyl ether, trimethylolpropane trivinyl ether, tetraethylene glycol divinyl ether, pentaerythritol divinyl ether, pentaerythritol trivinyl ether, pentaerythritol tetravinyl ether, 1,4-bis{2-(vinyloxy)ethyloxy}benzene, 1,2-bis{2-(vinyloxy)ethyloxy}benzene, 1,3-bis{2-(vinyloxy)ethyloxy}benzene, 1,3,5-tris{2-(vinyloxy)ethyloxy}benzene, 4,4'-bis{2-(vinyloxy)ethyloxy}biphenyl, 4,4'-bis{2-(vinyloxy)ethyloxy}diphenyl ether, 4,4'-bis{2-(vinyloxy)ethyloxy}diphenylmethane, 1,4-bis{2-(vinyloxy)ethyloxy}naphthalene, 2,5-bis{2-(vinyloxy)ethyloxy}furan, 2,5-bis{2-(vinyloxy)ethyloxy}thiophene, 2,5-bis{2-(vinyloxy)ethyloxy}imidazole, 2,2-bis[4-{2-(vinyloxy)ethyloxy}phenyl]propane {bis(vinyloxyethyl)ether of bisphenol-A}, 2,2-bis{4-(vinyloxymethyloxy)phenyl}propane, and 2,2-bis{4-(vinyloxy)phenyl}propane, but these examples are not restrictive.

On such addition polymerizable compounds, details of a method of use such as structures thereof, a single use or a combined use, an amount of addition and the like may be arbitrarily selected according to a final designing of the performance of the lithographic printing plate precursor. Such selection can be made for example from following points.

With respect to the sensitivity, a structure having a larger number of unsaturated groups per molecule is preferable, and two or more functional groups are preferred in most cases. Also for increasing the strength of the image area or the cured film, three or more functional groups are preferred, and it is also effective to regulate both the sensitivity and the strength by employing a combination of compounds different in the number of the functional groups and in the polymerizable group (such as an acrylate ester, a methacrylate ester, a styrene compound and a vinyl ether compound).

Also for a mutual solubility and a dispersibility with other components (such as water-insoluble polymer, initiator, colorant and the like) in the image recording layer, the selection and the method of use of the addition polymerizable compound are important factors, and, for example, the mutual solubility may be improved by employing a low-purity compound or by employing two or more kinds. Also a specific structure may be selected for the purpose of an adhesion property to the substrate or to a protective layer to be explained later.

The aforementioned polymerizable compound is preferably employed in an amount of 5 to 80 mass% with respect to the total solids constituting the image recording layer, more preferably 25 to 75 mass%. Also such compound may be employed singly or in a combination of two or more kinds.

Also in the use of the polymerizable compound, a suitable structure, a composition and an amount can be arbitrarily selected in consideration of a magnitude of polymerization inhibition by oxygen, a resolution, a fogging property, a change in the refractive index, a surface tackiness and the like, and a layer structure or a coating method such as an undercoating or an overcoating may also be adopted.

### <Infrared absorbing agent>

In a lithographic printing plate precursor which is subjected to an imagewise exposure with a light source of an infrared light, the image recording layer may contain an infrared absorbing agent in combination with the aforementioned polymerization initiator. The infrared absorbing agent has a function of converting an absorbed infrared light into heat, and thus generated heat induces a pyrolysis of the polymerization initiator to generate a radical. The infrared absorbing agent employed in the invention is a dye or a pigment, having an absorption maximum in a wavelength region of 760 to 1200 nm

The dye can be commercially available dyes and known ones described for example in "Senryo Binran (Dye Handbook)" (edited by Organic Synthetic Chemical Society, 1970). Specific examples of such dye include an azo dye, a metal complex azo dye, a pyrazolone azo dye, a naphthoquinone dye, an anthraquinone dye, a phthalocyanine dye, a carbonium dye, a quinonimine dye, a methine dye, a cyanine dye, a squalirium dye, a pyrilium dye, and a metal thiolate dye.

Preferred examples of the dye include a cyanine dye described in JP-A Nos. 58-125246, 59-84356 and 60-78787, a methine dye described in JP-A Nos. 58-173696, 58-181690 and 58-194595, a naphthoquinone dye described in JP-A Nos. 58-112793, 58-224793, 59-48187, 59-73996, 60-52940 and 60-63744, a squalirium dye described in JP-A No. 58-112792 and a cyanine dyes described in BP No. 434,875.

There can also be advantageously employed a near infrared absorption sensitizer described in USP No. 5,156,938, and there can be preferably employed a substituted arylbenzo(thio)pyrilium salt described in USP No. 3,881,924, a trimethinethiapyrilium salt described in JP-A No. 57-142645 (USP No. 4,327,169), a pyrilium compound described in JP-A Nos. 58-181051, 58-220143, 59-41363, 59-84248, 59-84249, 59-146063 and 59-146061, a cyanine dye described in JP-A No. 59-216146, a pentamethinethiopyrilium salt described in USP No. 4,283,475 and a pyrilium compound described in JP-B No. 5-13514 and 5-19702. Also another preferred example of the dye is a near infrared absorbing dye described in USP No. 4,756,993 by formulas (I) and (II).

Among these dyes, particularly preferred are a cyanine dye, a squalirium dye, a pyrilium salt, a nickel thiolate complex and an indoleninecyanine dye. A cyanine dye and an indoleninecyanine dye are further preferable, and a particularly preferable example is a cyanine dye represented by a following general formula (II).

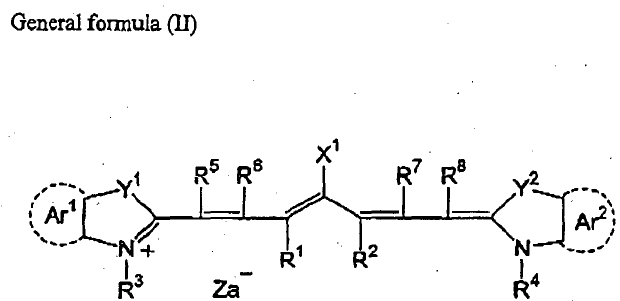

In the general formula (II), X¹ represents a hydrogen atom, a halogen atom, -NPh₂, X²-L¹ or a following group; X² represents an oxygen atom, a nitrogen atom or a sulfur atom; L¹ represents a hydrocarbon group with 1 to 12 carbon atoms, an aromatic ring having a hetero atom, or a hydrocarbon group with 1 to 12 carbon atoms including a hetero atom; and a hetero atom is N, S, O, a halogen atom or Se; Za⁻ is defined same as Xa⁻ shown in the following; and R^{a} represents a substituent selected from a hydrogen atom, an alkyl group, an aryl group, a substituted or non-substituted amino group and a halogen atom:

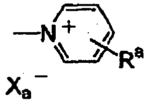

R¹ and R² each independently represents a hydrocarbon group of 1 to 12 carbon atoms. In consideration of stability in storage of a recording layer coating liquid, each of R¹ and R² is preferably a hydrocarbon group with 2 or more carbon atoms, and more preferably R¹ and R² are mutually bonded to form a five-membered ring or a six-membered ring.

Ar¹ and Ar², which may be same or different, each represents an aromatic hydrocarbon group which may have a substituent. Preferred examples of the aromatic hydrocarbon group include a benzene ring and a naphthalene ring. Also preferred examples of the substituent include a hydrocarbon group with 12 or less carbon atoms, a halogen atom, and an alkoxy group with 12 or less carbon atoms. Y¹ and Y², which may be same or different, each represents a sulfur atom or a dialkylmethylene group with 12 or less carbon atoms. R³ and R⁴, which may be same or different, each represents a hydrocarbon group with 20 or less carbon atoms, which may have a substituent preferred examples of the substituent include an alkoxy group with 12 or less carbon atoms, a carboxyl group and a sulfo group. R⁵, R⁶, R⁷ and R⁸, which may be same or different, each represents a hydrogen atom, or a hydrocarbon group with 12 or less carbon atoms. Hydrogen atom is preferred because of the availability of the raw material. Za represents a counter anion. However, Za⁻ is not required in case the cyanine dye represented by the general formula (II) has an anionic substituent within the structure thereof and does not require neutralization. In consideration of the stability in storage of a recording layer coating liquid, Za' is preferably a halogen ion, a perchlorate ion, a tetrafluoroborate ion, a hexafluorophosphate ion, or a sulfonate ion, and particularly preferably a perchlorate ion, a hexafluorophosphate ion or an arylsulfonate ion.

Specific examples of the cyanine dye represented by the general formula (II) and advantageously employable in the invention are described in paragraphs [0017] to [0019] of Japanese Patent Application No. 2001-133969.

Also other particularly preferable examples include a specified indoleninecyanine dye described in JP-A No. 2002-278057.

Examples of the pigment employable in the invention include commercially available pigments and pigments described in Color Index (C. 1.), "Saishin Ganryo Binran (Latest Pigment Handbook)" (Pigment Technology Society of Japan, 1977), "Saishin Ganryo Ouyou Gijutsu (Latest Pigment Application Technology)" (CMC Press, 1986), and "Insatsu Ink Gijutsu (Printing Ink Technology)" (CMC Press, 1984).

The type of the pigment can be a black pigment, an yellow pigment, an orange pigment, a brown pigment, a red pigment, a purple pigment, a blue pigment, a green pigment, a fluorescent pigment, a metal powder pigment, or a polymer bonded pigment. Specific examples include an insoluble azo pigment, an azo rake pigment, a condensed azo pigment, a chelate azo pigment, a phthalocyanine pigment, an anthraquinone pigment, perylene and perynone pigments, a thioindigo pigment, a quinachrydone pigment, a dioxazine pigment, an isoindolinone pigment, a quinophthalone pigment, a vat rake pigment, an azine pigment, a nitroso pigment, a nitro pigment, a natural pigment, a fluorescent pigment, an inorganic pigment and carbon black, among which preferred is carbon black.

These pigments may be used with or without a surface treatment. The surface treating method can be, for example, a method of surface coating with resin or wax, a method of depositing a surfactant, or a method of bonding a reactive substance (for example a silane coupling agent, an epoxy compound or polyisocyanate) to the pigment surface. These surface treating methods are described in "Kinzoku Sekken no Seishitsu to Ouyou (Properties and Applications of Metal Soaps)" (Saiwai Shobo), "Insatsu Ink Gijutsu (Printing Ink Technology)" (CMC Press, 1984) and "Saishin Ganryo Ouyou Gijutsu (Latest Pigment Application Technology)" (CMC Press, 1986).

The particle size of the pigment is preferably within a range of 0.01 to 10 µm, more preferably 0.05 to 1 µm and most preferably 0.1 to 1 µm. A particle size within such range provides a satisfactory stability of the pigment dispersion in the image recording layer coating liquid and a satisfactory uniformity of the image recording layer.

For dispersing the pigment, there can be used a known technology employed in ink manufacture or toner manufacture. A dispersing machine can be an ultrasonic dispersing device, a sand mill, an attriter, a pearl mill, a super mill, a ball mill, an impeller, a disperser, a KD mill, a colloid mill, a dynatron, a three-roll mill or a pressurized kneader. Details are described in "Saishin Ganryo Ouyou Gijutsu (Latest Pigment Application Technology)" (CMC Press, 1986).

Such infrared absorbing agent is preferably added in a necessary minimum amount in order to suppress a side effect hindering the polymerization reaction.

Such infrared absorbing agent may be added, to all the solids constituting the image recording layer, in an amount of 0.001 to 50 wt.%, preferably 0.005 to 30 wt.%, especially preferably, 0.01 to 10 wt.%. Within such range, a high sensitivity can be obtained without undesirable influences on the uniformity and the film strength of the image recording layer.

### <Sensitizer>

In a lithographic printing plate precursor which is subjected to an imagewise exposure with a light source of an infrared light of 250 - 420 nm, the image recording layer may contain a sensitizer in combination with the aforementioned polymerization initiator for improving the radical generating efficiency.

Specific examples of the sensitizer include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, thioxanthone, benzyl, dibenzalacetone, p-(dimethylamino)phenyl styryl ketone, p-(dimethylamino)phenyl p-methylstyryl ketone, benzophenone, p-(dimethylamino)benzophenone (or Michler's ketone), p-(diethylamino)benzophenone and benzanthrone.

Also a preferred sensitizer in the invention can be a compound represented by a general formula (III) in JP-B No. 51-48516.

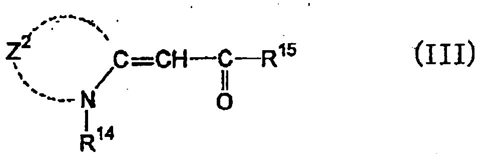

In the formula, R¹⁴ represents an alkyl group (such as a methyl group, an ethyl group or a propyl group), or a substituted alkyl group (such as a 2-hydroxyethyl group, a 2-methoxyethyl group, a carboxymethyl group or a 2-carboxyethyl group). R¹⁵ represents an alkyl group (such as a methyl group or an ethyl group) or an aryl group (such as a phenyl group, a p-hydroxyphenyl group, a naphthyl group or a thienyl group).

Z² represents a non-metal atomic group required for forming a nitrogen-containing heterocycle ordinarily employed in a cyanine dye, for example a benzothiazole (such as benzothiazole, 5-chlorobenzothiazole, or 6-chlorobenzothiazole), a naphthothiazole (α-naphthothiazole or β-naphthothiazole), a benzoselenazole (such as benzoselenazole, 5-chlorobenzoselenazole or 6-methoxybenzoselenazole), a naphthoselenazole such as α-naphthoselenazole or β-naphthoselenazole), a benzoxazole such as benzoxazole, 5-methylbenzoxazole or 5-phenylbenzoxazole) or a naphthoxazole (α-naphthoxazole or β-naphthoxazole).

Specific examples of the compound represented by the general formula (III) have a chemical structure formed by combining Z², R¹⁴ and R¹⁵, and are available as known substances, from which the compound can be suitably selected. Also a preferred sensitizer in the invention can be a merocyanine dye described in JP-B No. 5-47095, or a ketocoumarin compound represented by a following general formula (IV). Also a sensitizing dye described in JP-A Nos. 2001-100412 and 2003-221517 is advantageous for the sensitizer of the invention. 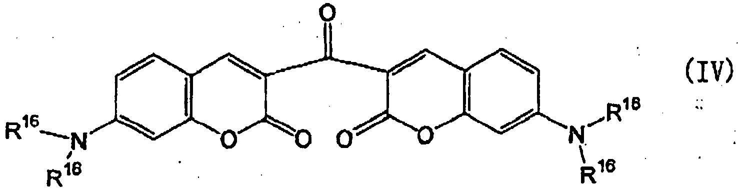 wherein R¹⁶ is an alkyl group such as a methyl group or an ethyl group.

Such sensitizer is preferably employed in an amount of 0.1 to 50 mass% with respect to the total solids constituting the image recording layer, more preferably 0.5 to 30 mass% and particularly preferably 0.8 to 20 mass%.

### <Microcapsules>

In the invention, for including the aforementioned constituents of the image recording layer and other constituents to be explained later in the image recording layer, a part of such constituents may be included in microcapsules and thus added to the image recording layer, as described in JP-A Nos. 2001-277740 and 2001-277742. In such case, each constituent may be present at an arbitrary ratio inside and outside the microcapsules.

For microencapsulating the constituents of the image recording layer, there can be applied a known method. For example, the microcapsules can be prepared by a method utilizing a coacervation as described in USP Nos. 2,800,457 and 2,800,458, a method utilizing an interfacial polymerization as described in USP No. 3,287,154 and JP-B Nos. 38-19574 and 42-446, a method utilizing a polymer precipitation described in USP Nos. 3,418,250 and 3,660,304, a method utilizing an isocyanate-polyol wall material as described in USP No. 3,796,669, a method utilizing an isocyanate wall material as described in USP No. 3,914,511, a method of utilizing an urea-formaldehyde or urea-formaldehyde-resorcinol wall material as described in USP Nos. 4,001,140,4,087,376 and 4,089,802, a method of utilizing a melamine-formaldehyde resin or hydroxycellulose as a wall material as described in USP No. 4,025,445, an in situ method utilizing a monomer polymerization as described in JP-B Nos. 36-9163 and 51-9079, a spray drying method described in BP No. 930,422 and USP No. 3,111,407, or an electrolytic dispersion cooling method as described in BP Nos. 952,807 and 967,074, but such methods are not restrictive.

A preferable micocapsule wall to be employed in the invention has a three-dimensional crosslinking and a property of swelling with a solvent. Based on such standpoint, the wall material for the microcapsules is preferably polyurea, polyurethane, polyester, polycarbonate, polyamide or a mixture thereof, and more preferably polyurea or polyurethane. Also in the microcapsule wall, there may be introduced a compound having a crosslinkable functional group such as an ethylenic unsaturated bond, that can be introduced into the aforementioned water-insoluble polymer.

The microcapsules have an average particle size of 0.01 to 3.0 µm, more preferably 0.05 to 2.0 µm, and particularly preferably 0.10 to 1.0 µm. A particle size within this range provides satisfactory resolution and stability in time.

### <Other components of image recording layer>

The image recording layer may contain, if necessary, various additives which will be explained in the following.

### <Surfactant>

The image recording layer preferably utilizes a surfactant for accelerating a developing property and improving a coated surface property. The surfactant can be, for example, a nonionic surfactant, an anionic surfactant a cationic surfactant, an amphoteric surfactant or a fluorinated surfactant. The surfactant may be employed singly or in a combination of two or more kinds.

A nonionic surfactant to be employed is not particularly restricted, and can be a known one, such as a polyoxyethylene alkyl ether, a polyoxyethylene alkylphenyl ether, a polyoxyethylene polyoxypropylenalkyl ether, a glycerin-fatty acid partial ester, a sorbitan-fatty acid partial ester, a pentaerythritol-fatty acid partial ester, a propylene glycol-fatty acid monoester, a glucose-fatty acid partial ester, a polyoxyethylenesorbitan-fatty acid partial ester, a polyoxyethylenesorbitol-fatty acid partial ester, a polyethylene glycol-fatty acid ester, a polyglycerin-fatty acid partial ester, a polyoxyethylenized castor oil, a polyoxyethyleneglycerin-fatty acid partial ester, a fatty acid diethanolamide, an N,N-bis-2-hydroxyalkylamine, a polyoxyethylene alkylamine, a triethanolamine-fatty acid ester, a trialkylaminoxide, polyethylene glycol, or a copolymer of polyethylene glycol and polypropylene glycol.

An anionic surfactant to be employed is not particularly restricted, and can be a known one, such as a fatty acid salt, an abietate salt, a hydroxyalkanesulfonate salt, an alkanesulfonate salt, a dialkylsulfosuccinate ester salt, a linear alkylbenzenesulfonate salt, a branched alkylbenzenesulfonate salt, an alkylnaphthalenesulfonate salt, an alkylphenoxypolyoxyethylene propylsulfonate salt, a polyoxyethylene alkylsulfophenyl ether salt, an N-methyl-N-oleyltaulin sodium salt, an N-alkylsulfosuccinic monoamide disodium salt, a petroleum sulfonate salt, sulfonated tallow oil, a sulfate ester salt of a fatty acid alkyl ester, an alkylsulfate ester salt, a polyoxyethylene alkyl ether sulfate ester salt, a fatty acid monoglyceride sulfate ester salt, a polyoxyethylene alkylphenyl ether sulfate ester salt, a polyoxyethylene styryl phenyl ether sulfate ester salt, an alkylphosphate ester salt, a polyoxyethylene alkyl ether phosphate ester salt, a polyoxyethylene alkylphenyl ether phosphate ester salt, a partial saponified product of a styrene-maleic anhydride copolymer, a partial saponified product of an olefin-maleic anhydride copolymer, or a naphthalenesulfonate salt-formalin condensate.

A cationic surfactant to be employed is not particularly restricted, and can be a known one, such as an alkylamine salt, a quaternary ammonium salt, a polyoxyethylenealkylamine salt, or a polyethylenepolyamine derivative.

An cationic surfactant to be employed is not particularly restricted, and can be a known one, such as a carboxybetain, an aminocarboxylic acid, a sulfobetain, an aminosulfate ester or an imidazoline.

In the foregoing surfactants, "polyoxyethylene" may be replaced by "polyoxyalkylene" such as polyoxymethylene, polyoxypropylene or polyoxybutylene, and such surfactants may also be employed in the present invention.

A further preferred surfactant is a fluorinated surfactant containing a perfluoroalkyl group within the molecule. Examples of such fluorinated surfactant include an amphoteric type such as a perfluoroalkylcarboxylate salt, a perfluoroalkylsulfonate salt or a perfluoroalkylphophate salt; an amphoteric type such as a perfluoroalkylbetain; a cationic type such as a perfluoroalkyltrimethyl ammonium salt; and a nonionic type such as a perfluoroalkylamine oxide, a perfluoroalkylethylene oxide addition product, an oligomer containing a perfluoroalkyl group and a hydrophilic group, an oligomer containing a perfluoroalkyl group and a hydrophilic group, an oligomer containing a perfluoroalkyl group and an oleophilic group, an oligomer containing a perfluoroalkyl group, a hydrophilic group and an oleophilic group, or an urethane containing a perfluoroalkyl group and an oleophilic group. Also there can be advantageously employed a fluorinated surfactant described in JP-A Nos. 62-170950, 62-226143 and 60-168144.

The surfactant may be employed singly or in a combination of two or more kinds.

A content of the surfactant is preferably 0.001 to 10 mass% with respect to the total solids of the image recording layer, more preferably 0.01 to 7 mass%.

### <Hydrophilic polymer>

A hydrophilic polymer may be included for improving a developing property and a dispersion stability of microcapsules.

A preferred hydrophilic polymer contains, for example, a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amide group, a carboxymethyl group, a sulfonic acid group or a phosphonic acid group.

Specific examples include gum Arabic, gelatin, a starch derivative, carboxymethyl cellulose and a derivative thereof, cellulose acetate, sodium alginate, a vinyl acetate-maleic acid copolymer, a styrene-maleic acid copolymer, a polyacrylic acid and a salt thereof, a polymethacrylic acid and a salt thereof, a homopolymer and a copolymer of hydroxyethyl methacrylate, a homopolymer and a copolymer of hydroxyethyl acrylate, a homopolymer and a copolymer of hydroxypropyl methacrylate, a homopolymer and a copolymer of hydroxypropyl acrylate, a homopolymer and a copolymer of hydroxybutyl methacrylate, a homopolymer and a copolymer of hydroxybutyl acrylate, a polyethylene glycol, a hydroxypropylene copolymer, a polyvinyl alcohol, a hydrolyzed polyvinyl acetate having a degree of hydrolysis of 60 mol.% or higher, preferably 80 mol.% or higher, polyvinylformal, polyvinylbutyral, polyvinylpyrrolidone, a homopolyer and a copolymer of acrylamide, a homopolyer and a copolymer of methacrylamide, a homopolyer and a copolymer of N-methyloladrylamide, polyvinylpyrrolidone, alcohol-soluble nylon, and a polyether of 2,2-bis-(4-hydroxyphenyl)-propane and epichlorhydrin.

The hydrophilic polymer preferably has a mass-average molecular weight of 5,000 or higher, and more preferably 10,000 to 300,000. The hydrophilic polymer may be a random polymer, a block polymer or a graft polymer.

A content of the hydrophilic polymer in the image recording layer is preferably 20 mass% or less in all the solids of the image recording layer, and more preferably 10 mass% or less.

### <Colorant>

A dye having a large absorption in the visible wavelength region may be used as a coloring agent for the image. Specific examples include Oil Yellow #101, Oil Yellow #103, Oil Pink #312, Oil Green BG, Oil Blue BOS, Oil Blue #603, Oil Black BY, Oil Black BS, Oil Black T-505 (foregoing manufactured by Orient Kagaku Kogyo Co., Ltd.), Victoria Pure Blue, Crystal Violet (CI42555), Methyl Violet (CI42535), Ethyl Violet, Rhodamine B (CII45170B), Marachite Green (CI42000), Methylene Blue (CI52015), and dyes described in JP-A No. 62-293247. Also there can be advantageously employed a pigment such as a phthalocyanine pigment, an azo pigment, carbon black or titanium oxide.

Addition of such coloring agent is preferred, as an image part and a non-image part can be easily distinguished after image formation. An amount of addition is within a range of 0.01 to 10 wt.% with respect to the total solids of the image recording layer.

### <Printout agent>

In the image recording layer, a compound causing a color change by an acid or a radical may be added for generating a printout image. For such compound, various dyes can be effectively employed such as a diphenylmethane dye, a triphenylmethane dye, a thiazine dye, an oxazine dye, a xanthene dye, an anthraquinone dye, an iminoquinone dye, an azo dye or an azomethine dye.

Specific examples include a dye such as Brilliant Green, Ethyl Violet, Methyl Green, Crystal Violet, Basic Fuchsine, Methyl Violet 2B, Quinaldine Red, Rose Bengal, Metanyl Yellow, Tymol Sulfophthalein, Xylenol Blue, Methyl Orange, Paramethyl Red, Congo Red, Benzopurpurin 4B, α-Naphthyl Red, Nile Blue 2B, Nile Blue A, Methyl Violet, Marachite Green, Parafuchsine, Victoria Pure Blue BOH [manufactured by Hodogaya Chemical Co.], Oil Blue #603 [manufactured by Orient Kagaku Kogyo Co.], Oil Pink #312 [manufactured by Orient Kagaku Kogyo Co.], Oil Red 5B [manufactured by Orient Kagaku Kogyo Co.], Oil Scarlet #308 [manufactured by Orient Kagaku Kogyo Co.], Oil Red OG [manufactured by Orient Kagaku Kogyo Co.], Oil Red RR [manufactured by Orient Kagaku Kogyo Co.], Oil Green #502 [manufactured by Orient Kagaku Kogyo Co.], Spiron Red BEG Special [manufactured by Hodogaya Chemical Co.], m-Cresol Purple, Cresol Red, Rhodamine B, Rhodamine 6G, Sulforhodamine B, Auramine, 4-p-diethylaminophenyliminonaphthoquinone, 2-carboxyanilino-4-p-diethylaminophenyliminonaphthoquinone, 2-carboxystearyeamino-4-p-N, N-bis (hydroxyethyl) aminophenyliminonaphthoquinone, 1-phenyl-3-methyl-4-p-diethylaminophenylimino-5-pyrazolone and 1-B-naphtyl-4-p-diethylaminophenylimino-5-pyrazolone, and a leuco dye such as p,p',p"-hexamethyltriamino-triphenylmethane (leuco crystal violet) or Pergascript Blue SRB (manufactured by Ciba Geigy Ltd.).

In addition to the foregoing, there can also be advantageously employed a leuco dye known for a thermal paper or a pressure sensitive paper. Specific examples include crystal violet lactone, marachite green lactone, benzoyl leuco methylene blue, 2-(N-phenyl-N-methylamino)-6-(N-p-tolyl-N-ethyl)amino-fluorane, 2-anilino-3-methyl-6-(N-ethyl-p-toluidino)fluorane, 3,6-dimethoxyfluorane, 3-(N,N-diethylamino)-5-methyl-7-(N,N-dibenzylamino)-fluorane, 3-(N-cyclohexyl-N-methylamino)-6-methyl-7-anilinofluorane, 3-(N,N-diethylamino)-6-methyl-7-anilinofluorane, 3-(N,N-diethylamino)-6-methyl-7-xylidinofluorane, 3-(N,N-diethylamino)-6-methyl-7-chlorofluorane, 3-(N,N-diethylamino)-6-metboxy-7-aminofluorane, 3-(N,N-diethylamino)-7-(4-chloroanilino)fluorane, 3-(N,N-diethylamino)-7-chlorofluorane, 3-(N,N-diethylamino)-7-benzylaminofluorane, 3-(N,N-diethylamino)-7,8-benzofluorane, 3-(N,N-dibutylamino)-6-methyl-7-anilinofluorane, 3-(N,N-dibutylamino)-6-methyl-7-xylidinofluorane, 3-piperidino-6-methyl-7-anilinofluorane, 3-pyrrolidino-6-methyl-7-anilinofluorane, 3,3-bis(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxypohenyl)-3-(1-ethyl-2-methylindol-3-yl)-4-phthalide, and 3-(4-diethylaminophenyl)-3-(1-ethyl-2-methylindol-3-yl)phthalide.

A preferred amount of the dye causing a color change by an acid or a radical is 0.01 to 15 mass% with respect to the solids of the image recording layer.

### <Polymerization inhibitor>

In the image recording layer, in order to prevent an unnecessary thermal polymerization of the radical polymerizable compound during the preparation or the storage of the image recording layer, it is desirable to add a small amount of a thermal polymerization inhibitor.

Examples of the thermal polymerization inhibitor include hydroquinone, p-methoxyphenol, di-t-butyl-p-cresol, pyrogarol, t-butylcatechol, benzoquinone, 4,4'-thiobis(3-methyl-6-t-butylphenol), 2,2'-methnylenebis(4-methyl-6-1-butylphenol) and N-nitroso-N-phenylhydroxylamine aluminum salt.

An addition amount of the thermal polymerization inhibitor is preferably about 0.01 to wt.% with respect to the solids of the image recording layer.

### <Higher fatty acid derivative>

In the image recording layer, in order to prevent inhibition of polymerization by oxygen, a higher fatty acid derivative such as behenic acid or behenic acid amide may be added and made to be present locally at the surface of the image recording layer in the course of a drying step after coating. An addition amount of such higher fatty acid derivative is preferably about 0.1 to 10 wt.% with respect to the entire composition.

### <Plasticizer>

The image recording layer may contain a plasticizer. Examples of the plasticizer include a phthalate ester such as dimethyl phthalate, diethyl phthalate, dibutyl phthalate, diisobutyl phthalate, dioctyl phthalate, octyl capryl phthalate, dicyclohexyl phthalate, ditridecyl phthalate, butyl benzyl phthalate, diisodecyl phthalate or diallyl phthalate; a glycol ester such as dimethyl glycol phthalate, ethylphthalyl ethyl glycolate, methylphthalyl ethyl glycolate, butylphthalyl butyl glycolate, or triethylene glycol dicaproate ester; a phosphate ester such as tricresyl phosphate, or triphenyl phosphate; an aliphatic dibasic acid ester such as diisobutyl adipate, dioctyl adipate, dimethyl sebacate, dibutyl sebacate, dioctyl azelate or dibutyl maleate; polyglycidyl methacrylate, triethyl citrate, glycerin triacetyl ester or butyl laurate. A content of the plasticizer is preferably about 30 mass% or less with respect to the total solids of the image recording layer.

### <Inorganic particles>

The image recording layer may contain inorganic particles for improving the strength of the cured film in the image area. The inorganic particles can advantageously be, for example, of silica, alumina, magnesium oxide, titanium oxide, magnesium carbonate, calcium alginate or a mixture thereof. Such material, even not having a photothermal converting property, can be employed for reinforcing the film or reinforcing an interfacial adhesion by a surface roughening. The inorganic particles preferably have an average particle size of 5 nm to 10 µm, more preferably 0.5 to 3 µm. A material within such range can be stably dispersed in the image recording layer to maintain a sufficient film strength in the image recording layer and can form a non-image area with an excellent hydrophilicity, not easily causing a smear at the printing operation.

The inorganic particles mentioned above are easily available as a commercial product such as a colloidal silica dispersion.

A content of the inorganic particles is preferably 20 mass% or less with respect to the total solids of the image recording layer, more preferably 10 mass% or less.

### <Low-molecular hydrophilic compound>

The image recording layer may contain a hydrophilic low-molecular compound for improving the developing property. Examples of the hydrophilic low-molecular compound include, as a water-soluble organic compound, a glycol, an ester or an ester derivative thereof such as ethylene glycol, diethylene glycol, triethylene glycol, propylene glycol, dipropylene glycol or tripropylene glycol; a polyhydroxy compound such as glycerin or pentaerythritol; an organic amine or a salt thereof such as triethanolamine, diethanolamine or monoethanolamine; an organic sulfonic acid or a salt thereof such as toluenesulfonic acid or benzenesulfonic acid; an organic phosphonic acid or a salt thereof such as phenylphosphonic acid; and an organic carboxylic acid or a salt thereof such as tartaric acid, oxalic acid, citric acid, malic acid, lactic acid, gluconic acid or an amino acid.

### [On-press developable image recording layer]

A lithographic printing plate precursor to be employed in the planographic printing method of the invention includes, on a substrate, a negative image recording layer which is removable by a printing and/or a fountain solution and which is cured by an exposure. Such on-press developable negative image recording layer is not particularly restricted, but is preferably a polymerizable image recording layer containing a polymerization initiator and a polymerizable compound, for attaining an easy developability and a satisfactory run length.

The polymerization initiator and the polymerizable compound to be employed in the on-press developable negative image recording layer can be a polymerization initiator and a polymerizable compound described in the foregoing.

Such on-press developable image recording layer may include a binder polymer for improving the film strength of the image recording layer. As the binder polymer, any known material may be employed without restriction but a polymer having a film forming property is preferred. Examples of such binder polymer include, in addition to the aforementioned water-insoluble polymers, a polyurea resin, a polyimide resin, a novolac type phenolic resin, synthetic rubber and natural rubber.

The binder polymer may have a crosslinking property in order to improve the film strength of the image area. For providing the binder polymer with a crosslinking property, a crosslinkable functional group such as an ethylenic unsaturated bond may be introduced into the polymer. The crosslinkable functional group may be introduced by a copolymerization.

Examples of the polymer having an ethylenic unsaturated bond in a main chain of the molecule include poly-1,4-butadiene and poly-1,4-isoprene. Also examples of the polymer having an ethylenic unsaturated bond in a side chain of the molecule can be same as those for the water-insoluble polymer described before.

Also for attaining the on-press developability for an unexposed area of the image recording layer, the binder polymer preferably has a high solubility or a high dispersibility in the ink and/or the fountain solution.

For improving the solubility or the dispersibility in the ink, the binder polymer is preferably oleophilic, and, for improving the solubility or the dispersibility in the fountain solution, the binder polymer is preferably hydrophilic. For this reason, it is also effective, in the invention, to employ an oleophilic binder polymer and a hydrophilic binder polyer in combination.

Examples of the hydrophilic binder polymer can be same as those for the hydrophilic polymer mentioned before.

The on-press developable image recording layer may include, in addition to the polymerization initiator, the polymerizable compound and the binder polymer, an infrared absorbing agent, a sensitizer, microcapsules, a surfactant, a colorant, a printout agent, a polymerization inhibitor, a higher fatty acid derivative, a plasticizer, inorganic particles, and a low-molecular hydrophilic compound in the aforementioned amounts of addition, according to the necessity.

### [Formation of image recording layer]

The image recording layer of the plate precursor used in the present invention can be prepared by dissolving or dispersing the aforementioned necessary components in a solvent to prepare a coating liquid and by coating such liquid. Examples of the solvent to be used include ethylene dichloride, cyclohexanone, methyl ethyl ketone, methanol, ethanol, propanol, ethylglycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethyl-urea, N-methylpyrrolidone, dimethylsulfoxide, sulfolane, γ-butyrolactone, toluene, and water but these examples are not restrictive. These solvents may be used singly or in a mixture thereof. The solid concentration of the coating liquid is preferably 1 to 50 wt.%

The image recording layer of the plate precursor used in the present invention may also be produced by preparing plural coating liquids by dispersing or dissolving same or different components mentioned above in same or different solvents and by repeating coating and drying operations plural times.

Also a coating amount (solid) of the image recording layer obtained on the substrate after coating and drying is variable depending on the purpose of use, but there is generally preferred a range of 0.3 to 3.0 g/m². An amount within such range can provide a satisfactory sensitivity and a satisfactory film property in the image recording layer.

The coating can be achieved by various methods, such as bar coating, spin coating, spray coating, curtain coating, immersion coating, air knife coating, blade coating or roller coating.

### [Substrate]

A substrate to be employed in the lithographic printing plate precursor used in the invention is not particularly limited as long as it is a dimensionally stable plate-shaped member and can be, for example, paper, paper laminated with a plastic material (for example of polyethylene, polypropylene or polystyrene), a metal plate (for example aluminum, zinc or copper), a plastic film (for example cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinylacetal), or paper or a plastic film laminated or evaporated with the aforementioned metal. A preferred substrate is a polyester film or an aluminum plate. Among these, there is preferred an aluminum plate which has a satisfactory dimensional stability and is relatively inexpensive.

The aluminum plate is a pure aluminum plate, or an alloy plate principally composed of aluminum and containing another element in a small amount, or a thin film of aluminum or an aluminum alloy on which plastics is laminated. The another element contained in the aluminum alloy may be silicon, iron, manganese, copper, magnesium, chromium, zinc, bismuth, nickel and/or titanium. The content of another element in the alloy is preferably 10 wt.% or less. In the present invention, pure aluminum is preferred, but there may be used aluminum containing another element in a small amount since completely pure aluminum is difficult to produce in the refining technology. The aluminum plate employable in the invention is not specified in the composition thereof but there can be suitably utilized an aluminum plate of an already known and utilized material.

A thickness of the substrate is preferably 0.1 to 0.6 mm, preferably 0.15 to 0.4 mm, particularly preferably 0.2 to 0.3 mm.

The aluminum plate is preferably subjected, prior to the use thereof, to a surface treatment such as surface roughing or anodizing. Such surface treatment allows to improve the hydrophilicity and to secure an adhesion between the image recording layer and the substrate. Prior to the surface roughing of the aluminum plate, there is conducted, if desired, a degreasing process for example with a surfactant, an organic solvent or an aqueous alkali solution, in order to remove pressing oil on the surface.

The roughing process of the surface of the aluminum plate can be executed by various methods, for example a mechanical roughing method, an electrochemical roughing method (a method of surface roughing by electrochemically dissolving the surface), or a chemical roughing method (a method of selectively dissolving the surface chemically).

For the mechanical method, there can be employed a known method such as a ball abrading method, a brush abrading method, a blast abrading method or a buff abrading method.

Also as the electrochemical roughing method, there is known a method utilizing an AC current or a DC current in an electrolyte solution of hydrochloric acid or nitric acid. Also there can be utilized a method of utilizing mixed acids, as described in JP-A No. 54-63902.

Thus surface roughed aluminum plate is subjected, if necessary, to an alkali etching with an aqueous solution of potassium hydroxide or sodium hydroxide, and, after a neutralization, to an anodizing process if necessary for improving an abrasion resistance.

For the anodizing process of the aluminum plate, there can be employed various electrolytes capable of forming an oxide film. In general there is employed sulfuric acid, hydrochloric acid, oxalic acid, chromic acid or a mixture thereof. A concentration of such electrolyte is suitably determined according to the type of the electrolyte.

Conditions of the anodizing process are variable depending on the electrolyte to be used and cannot be specified uniquely, but preferably include, in general, a concentration of the electrolyte in solution of 1 to 80 wt.%, a solution temperature of 5 to 70°C, a current density of 5 to 60 A/dm², a voltage of 1 to 100 V, and an electrolysis time of 10 seconds to 5 minutes. An amount of the anodized oxide film is preferably 1.0 to 5.0 g/m², more preferably 1.5 to 4.0 g/m². An amount within such range provides a satisfactory run length and a satisfactory scratch resistance in a non-image area of the lithographic printing plate.

The substrate subjected to the surface treatment and having the anodized oxide film as explained above may be employed as the substrate of the invention, but, for further improving the adhesion to the upper layer, the hydrophilicity, the smear resistance and the heat insulating property if necessary, may be subjected to a micropore widening process or a micropore sealing process in the anodized oxide film as described in JP-A Nos. 2001-253181 and 2001-322365, or a surface hydrophilizing process by immersing in an aqueous solution containing a hydrophilic compound. Naturally such widening process, or sealing process is not limited to those described above but any known method may also be employed.

The sealing process can be executed by a steam sealing, a sealing process with an aqueous solution containing an inorganic fluorine compound such a single process with fluorinated zirconic acid or a process with sodium fluoride, a steal sealing with an addition of lithium chloride, or a sealing process with hot water.

Among these, a sealing process with an aqueous solution containing an inorganic fluorine compound, a sealing process with stream or a sealing process with hot water is preferred.

For a hydrophilizing process, there is known an alkali metal silicate method as described in USP Nos. 2,714,066, 3,181,461, 3,280,734 and 3,902,734. In this method, the substrate is immersed in or electrolyzed in an aqueous solution such as of sodium silicate. Also there can be utilized a method of treating with potassium fluorinated zirconate as described in JP-B No. 36-22063, or a method of treating with polyvinylphosphonic acid as described in USP Nos. 3,276,868, 4,153,461 and 4,689,272.

In case of employing a substrate with an insufficient hydrophilicity such as a polyester film as the substrate of the invention, a hydrophilic layer is preferably coated to obtain a hydrophilic surface. The hydrophilic layer is preferably a hydrophilic layer obtained by coating a coating liquid containing a colloid of an oxide or a hydroxide of at least an element selected from beryllium, magnesium, aluminum, silicon, titanium, boron, germanium, tin, zirconium, iron, vanadium, antimony and a transition metal as described in JP-A No. 2001-199175, a hydrophilic layer having an organic hydrophilic matrix obtained by crosslinking or pseudo crosslinking an organic hydrophilic polymer as described in JP-A No. 2002-79772, a hydrophilic layer having an inorganic hydrophilic matrix obtained by a sol-gel conversion by a hydrolysis or a condensation reaction of a polyalkoxysilane, a titanate, a zirconate or an aluminate, or a hydrophilic layer formed by an inorganic thin film having a surface containing a metal oxide. Among these, there is preferred a hydrophilic layer obtained by coating a coating liquid containing a colloid of silicon oxide or hydroxide.

Also in case of employing a polyester film as the substrate, an antistatic layer is preferably provided on a side of the hydrophilic layer of the substrate and/or a side of the opposite side thereof. An antistatic layer, in case provided between the substrate and the hydrophilic layer, also contributes to the adhesion to the hydrophilic layer. The antistatic layer can be, for example, a polymer layer in which metal oxide particles and a matting agent are dispersed as described in JP-A No. 2002-79772.

The substrate preferably has a center line average roughness of 0.10 to 1.2 µm. A roughness within such range allows to provide a satisfactory adhesion to the image recording layer, a satisfactory length of run and a satisfactory smear resistance.

Also the substrate preferably has a color density of 0.15 to 0.65 in a reflective density. A density within such range allows to obtain a satisfactory image forming property by an antihalation at the image exposure, and a satisfactory plate inspection property after the development.

### [Undercoat layer]

In the lithographic printing plate precursor used in the invention, an undercoat layer of a compound having a polymerizable group is preferably provided on the substrate. In case of utilizing an undercoat layer, the image recording layer is provided thereon. The undercoat layer strengthens an adhesion between the substrate and the image recording layer in an exposed area, and, in an unexposed area, facilitates a peeling of the image recording layer from the substrate, thereby improving the developing property.

In the undercoat layer, there can be advantageously employed a silane coupling agent having a reactive group of an ethylenic double bond capable of an addition polymerization as described in JP-A No. 10-282679, and a phosphor compound having a reactive group of an ethylenic double bond as described in JP-A No. 2-304441. A particularly preferred compound is a compound having a polymerizable group such as a methacryl group or an allyl group, and a group adsorbable to the substrate such as a sulfonic acid group, a phosphoric acid group, or a phosphate ester. There can also be advantageously employed a compound having a hydrophilicity providing group such as an ethylene oxide group in addition to the polymerizable group and the group adsorbable to the substrate.

A coating amount (solid) of the undercoat layer is preferably 0.1 to 100 mg/m², and more preferably 1 to 30 mg/m².

### [Protective layer]

In the lithographic printing plate precursor used in the invention, a water-soluble protective layer (also called an overcoat layer) may be provided on the image recording layer, for the purposes of preventing a scratch in the image recording layer, intercepting oxygen and preventing an ablation at an exposure with a laser of a high illumination intensity.

In the invention, the exposure is usually conducted in the air, and the protective layer prevents a migration of a low-molecular compound such as oxygen or a basic substance in the air, which inhibits an image forming reaction taking place in the image recording layer by an exposure, thereby avoiding an inhibition of the image forming reaction by the exposure in the air. Consequently the protective layer is required to have a low transmission to the low-molecular compound such as oxygen, and additionally to have a satisfactory transmission to the light to be employed for the exposure, to have an excellent adhesion to the image recording layer and to be easily removable with an aqueous solution for a simplified development after the exposure. The protective layer having such characteristics has been investigated in various researches and is described in detail for example in USP No. 3,458,311 and JP-B No. 55-49729.

A material to be employed in the protective layer can be, for example, a water-soluble polymer compound having a relatively high crystallinity. More specifically, there can be employed a water-soluble polymer such as polyvinyl alcohol, polyvinylpyrrolidone, an acidic cellulose, gelatin, gum Arabic, or polyacrylic acid. Among these, polyvinyl alcohol (PVA) employed as a principal component provides optimum results on the basic characteristics such as an intercepting property and a removability by development. The polyvinyl alcohol may be partially substituted with an ester, an ether or an acetal and may partially have another copolymer component, as long as it contains a non-substituted vinyl alcohol unit for providing the oxygen intercepting property and the aqueous solubility required for the protective layer.

More specifically, polyvinyl alcohol advantageously is hydrolyzed by 71 to 100 % and has a polymerization degree within a range of 300 to 2400. Specific examples include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8, manufactured by Kuraray Co.

Components (selection of PVA and use of additives), a coating amount and the like of the protective layer are suitably selected in consideration of the oxygen intercepting property and the removability by development, and also of a fog property, an adhesion, a scratch resistance and the like. In general, a higher rate of hydrolysis of PVA (namely a higher content of the unsubstituted vinyl alcohol unit in the protective layer) and a larger film thickness provide a higher oxygen intercepting property, thus being favorable for the sensitivity. Also it is preferable that the oxygen intercepting property is not excessively high, in order to prevent an unnecessary polymerization reaction at the manufacture or at the storage, an unnecessary fog at the image exposure and a thickening of image lines. Therefore the oxygen intercepting property A at 25°C under an atmospheric pressure preferably meets a condition 0.2 ≤A≤ 20 (cm³/m²·day).

Also as other components of the protective layer, glycerin, dipropylene glycol or the like may be added by several mass% with respect to the (co)polymer for providing a flexibility, and an anionic surfactant such as sodium alkylsulfate or sodium alkylsulfonate, an amphoteric surfactant such as an alkylaminocarboxylic acid salt or an alkylaminodicarboxylic acid salt, or a nonionic surfactant such as polyoxyethylene alkylphenyl ether may be added by several mass% with respect to the water-soluble polymer.

Also an adhesion to the image area and a scratch resistance are very important in the handling of the lithographic printing plate precursor. When a protective layer which is hydrophilic by the presence of the water-soluble polymer compound is laminated on the oleophilic image recording layer, the protective layer may be peeled off by a deficient adhesive power and there may result, in such peeled portion, a defect such as an insufficient film curing resulting from a polymerization inhibition by oxygen.

Against such drawback, various proposals are made for improving the adhesion between the image recording layer and the protective layer. For example JP-A No. 49-70702 describes a method of mixing, in a hydrophilic polymer principally constituted of polyvinyl alcohol, an acrylic emulsion or a water-insoluble vinylpyrrolidone-vinyl acetate copolymer by 20 - 60 mass% and laminating such mixture on the image recording layer thereby obtaining a sufficient adhesive power. Any such known technology may be adopted in the invention.

The protective layer may be provided with other functions. For example by adding a colorant (for example a water-soluble dye) having an excellent transmission to the infrared light employed for exposure and capable of efficiently absorbing the light of other wavelengths, it is possible to improve a matching with a safelight without causing a loss in the sensitivity.

The protective layer has a thickness of 0.1 to 5 µm, preferably 0.2 to 2 µm.

A coating method for the protective layer is described for example in USP No. 3,458,311 and JP-B No. 55-49729.

### [Back coat layer]

After the is subjected to a surface treatment or an undercoating as explained above, a back coating may be provided on the rear surface of the substrate if necessary.

Such back coating is preferably formed by a coated layer of an organic polymer compound described in JP-A No. 5-45885, or a metal oxide obtained by hydrolysis and condensation polymerization of an organic or inorganic metal compound as described in JP-A No. 6-35174. Among these, there is preferred a silicon alkoxy compound such as Si(OCH₃)₄, Si(OC₂H₅)₄, Si(OC₃H₇)₄ or Si(OC₄H₉)₄.

### [Examples]

In the following, the present invention will be clarified in more details by examples thereof, but the present invention is not limited by such examples.

### [Preparation of substrate]

### <Substrate A>

An aluminum plate of a thickness of 0.3 mm (grade 1050) was at first subjected to a degreasing with a 10 % aqueous solution of sodium aluminate for 30 seconds at 50°C in order to remove the rolling oil on the surface, then subjected to a graining of aluminum surface, utilizing three nylon brushes with bundles of a fiber of a radius of 0.3 mm and an aqueous suspension (specific gravity of 1.1 g/cm³) of pumice of a median diameter of 25 µm, and rinsed well with water. The plate was etched by immersing in a 25 mass% aqueous solution of sodium hydroxide of 45°C for 9 seconds, and, after rinsing with water, immersed in a 20 mass% nitric .acid for 20 seconds at 60°C and rinsed with water. An etching amount of the grained surface as about 3 g/cm².

Then a continuous electrochemical graining treatment was conducted with an AC voltage of 60 Hz, utilizing an electrolyte of a 1 mass% aqueous solution of nitric acid (containing aluminum ions by 0.5 mass%) maintained at 50°C. The electrochemical graining was executed employing an AC voltage of a trapezoidal wave form having a time TP from a zero current to a peak current of 0.8 msec, and a duty ratio 1:1, utilizing a carbon counter electrode and an auxiliary anode of ferrite. A current density was 30 A/dm² at the peak current, and 5% of the current from the power source was branched to the auxiliary anode. The nitric acid electrolysis was conducted with an electricity of 175 C/dm² when the aluminum plate was the anode. Then the plate was spray rinsed with water.

Then an electrochemical graining was executed, in a similar manner as the nitric acid electrolysis, employing an electrolyte of a 0.5 mass% aqueous solution of hydrochloric acid (containing aluminum ions by 0.5 mass%) maintained at 50°C with an electricity of 50 C/dm² when the aluminum plate was the anode, followed by a spray rinsing with water. Then the plate was subjected to a formation of a DC anodized oxide film of 2.5 g/m² at a current density of 15 A/dm², utilizing 15 mass% sulfuric acid (containing aluminum ions by 0.5 mass%) as an electrolyte, then rinsed with water and dried to obtain a base plate S.

Then it was processed with a 2.5 mass% aqueous solution of sodium silicate for 10 seconds at 30°C, rinsed with water and dried to obtain a substrate A.

### <Substrate B>

The base plate S was immersed in a solution containing sodium fluorozirconate by 0.1 mass% and sodium dihydrogenphosphate by 1 mass%, having a pH value 3.7 and heated to 75°C, for 10 seconds to execute a pore sealing process, then rinsed with water, further processed with sodium silicate as in the substrate A, rinsed with water and dried to obtain a substrate B.

### <Substrate C>

The base plate S was subjected to a widening process for the pores of the anodized oxide film by processing in a 1 mass% aqueous solution of sodium hydroxide for 10 seconds at 60°C. Through this process, the pore diameter in the anodized oxide film was widened to 20 nm.

After such pore widening process, the plate was immersed in a solution containing sodium fluorozirconate by 0.1 mass% and sodium dihydrogenphosphate by 1 mass%, having a pH value 3.7 and heated to 75°C, for 10 seconds to execute a pore sealing process, then rinsed with water, further processed with sodium silicate as in the substrate A, rinsed with water and dried to obtain a substrate C.

### <Substrate D>

The base plate S was exposed to a saturated water vapor environment of 100°C for 10 seconds to execute a pore sealing process, then processed with sodium silicate as in the substrate A, rinsed with water and dried to obtain a substrate D.

In the substrates A - D, a center line average roughness (Ra) measured with a probe of a diameter of 2 µm was 0.51 µm.

A following undercoating liquid (1) was coated on the substrates A - D so as to obtain a dry coating amount of 10 mg/m² to obtain substrates (A) - (D) to be employed in following experiments:

### Undercoating liquid (1)

| | |
|---|---|
| following undercoating compound (1) | 0.017 g |
| methanol | 9.00 g |
| water | 1.00 g |
| undercoating compound (1) | |
| 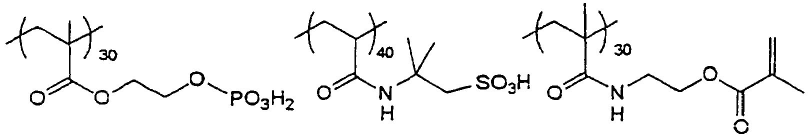 | |

### [Examples 1 - 12 (not in accordance with the invention) and Comparative Examples 1, 2]

### 1. Preparation of lithographic printing plate precursor

### <Lithographic printing plate precursor (1)>

An image recording layer coating liquid (1) of a following composition was bar coated on the substrate (A), and oven dried for 60 seconds at 160°C to form an image recording layer of a dry coating amount of 1.0 g/m² thereby obtaining a lithographic printing plate precursor (1).

The water-insoluble polymer (1) had a glass transition temperature (Tg) of 45°C, in a measurement with a scanning differential calorimeter DSC 200 manufactured by Seiko Instruments Inc. under a condition of a temperature elevating rate of 10°C/min within a range from -100°C to 150°C

### Image recording layer coating liquid (1)

| | |
|---|---|
| following water-insoluble polymer (1) | 0.65 g |
| following polymerization initiator (1) | 0.10 g |
| following infrared absorbing agent (1) | 0.018 g |
| polymerizable compound, Aronix M-215, manufactured by Toa Gosei Co. | 0.27 g |
| water-soluble fluorinated surfactant (1) | 0.044 g |
| methyl ethyl ketone | 9.0 g |
| water-insoluble polymer (1) | |
| 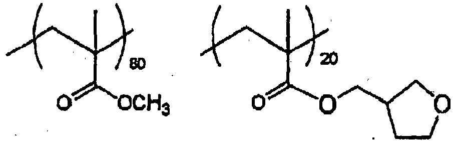 | |
| polymerization initiator (1) | |
| 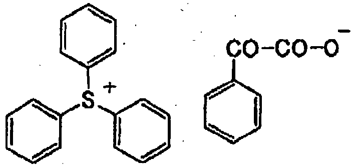 | |
| infrared absorbing agent (1) | |
| 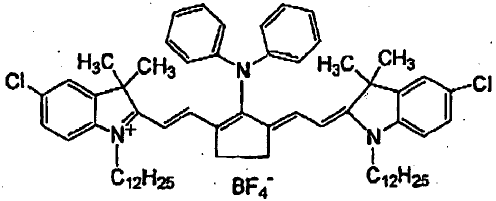 | |
| fluorinated surfactant (1) | |
| 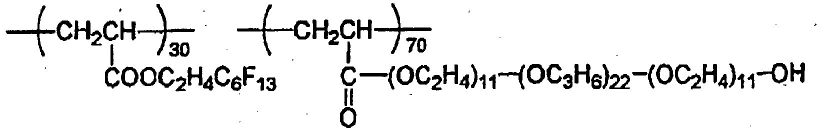 | |

### <Lithographic printing plate precursors (2) - (4) and comparative lithographic printing plate precursor (1')>

Lithographic printing plate precursors (2) - (4) and a lithographic printing plate precursor (1') for comparison were obtained in the same manner as the preparation of the lithographic printing plate precursor (1) except that the water-insoluble polymer (1) therein was changed to water-insoluble polymers shown in Table 1.

**Table 1: water-insoluble polymers for Lithographic printing plate precursors (2) - (4) and (1')**

| lithographic printing plate precursor | water-insoluble polymer | solubility | Tg |
|---|---|---|---|
| (2) | 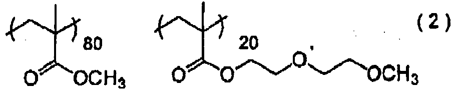 | water-insoluble | 49°C |
| (3) | 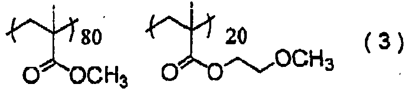 | water-insoluble | 77°C |
| (4) | 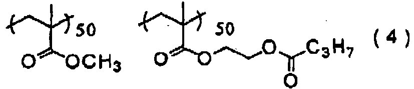 | water-insoluble | 9°C |
| (1') | 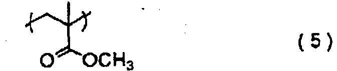 | water-insoluble | 105°C |

### <Lithographic printing plate precursor (5)>

An image recording layer coating liquid (2) of a following composition was bar coated on the substrate (A), then oven dried for 60 seconds at 100°C to form an image recording layer of a dry coating amount of 1.0 g/m², further coated thereon with a protective layer coating liquid (1) of a following composition so as to obtain a dry coating amount of 0.5 g/m² and dried for 1 minute at 120°C, thereby obtaining a lithographic printing plate precursor (5):

### Image recording layer coating liquid (2)

| | | |
|---|---|---|
| following polymerization initiator (2) | | 0.2 g |
| water-insoluble polymer (1) described above | | 12.0 g |
| polymerizable compound | | 6.0 g |
| | isocyanuric acid EO denatured triacrylate | |
| | (Aronix M-315,manufactured by Toa Gosei Co.) | |
| following compound C-1 | | 1.5 g |
| leuco crystal violet | | 3.0 g |
| thermal polymerization inhibitor | | 0.1 g |
| | N-nitrosophenylhydroxyl amine aluminum salt | |
| water-soluble fluorinated surfactant (1) described above | | 0.1 g |
| methyl ethyl ketone | | 70.0 g |
| | polymerization initiator (2) | |
| | 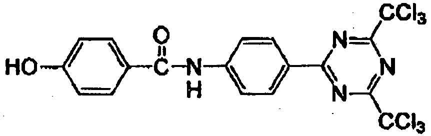 | |
| | compound C-1 | |
| | 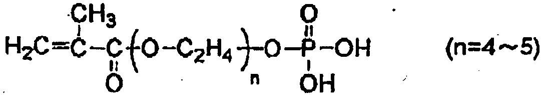 | |

### Protective layer coating liquid (1)

| | |
|---|---|
| polyvinyl alcohol (saponification degree 95 mol.%, polymerization degree 800) | 40 g |
| polyvinylpyrrolidonc (molecular weight 50,000) | 5 g |
| poly(vinylpyrrolidone/vinyl acetate (1/1)), (molecular weight 70,000) | 5 g |
| following nonionic surfactant (1) | 3 g |
| water | 950 g |
| nonionic surfactant (1) | |
| 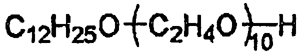 | |

### <Lithographic printing plate precursor (6)>

An image recording layer coating liquid (3) of a following composition was bar coated on the substrate (A), and oven dried for 60 seconds at 100°C to form an image recording layer of a dry coating amount of 1.0 g/m², thereby obtaining a lithographic printing plate precursor (6). The image recording layer coating liquid (3) was obtained by mixing under agitation a following photosensitive liquid (1) and a microcapsule liquid (1) immediately before coating. A water-insoluble polymer (6) had a glass transition temperature of 30°C.

### Photosensitive liquid (1):

| | |
|---|---|
| water-insoluble polymer (6) | 0.5 g |
| polymerization initiator (1) described above | 0.100 g |
| infrared absorbing agent (1) described above | 0.020 g |
| polymerizable compound, Aronix M-215, manufactured by Toa Gosei Co. | 0.2 g |
| water-soluble fluorinated surfactant (1) described above | 0.044 g |
| methyl ethyl ketone | 1.091 g |
| 1-methoxy-2-propanol | 8.609 g |
| water-insoluble polymer (6) | |
| 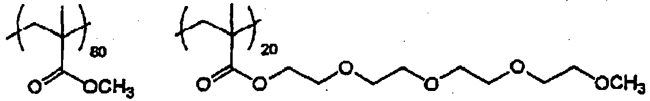 | |

### Microcapsule liquid (1):

| | |
|---|---|
| microcapsules synthesized as follows | 2.640 g |
| water | 2.425 g |

### Synthesis of microcapsules (1)

As an oil phase component, 10 g of a trimethylolpropane-xylene diisocyanate addition product (Takenate D-110N, manufactured by Mitsui-Takeda Chemical Co.), 3.15 g of pentaerythritol triacrylate (SR444, manufactured by Nippon Kayaku Co.), 0.35 g of a following infrared absorbing agent (2), 1 g of 3-(N',N-diethylamino)-6-methyl-7-anilinofluoran (ODB, manufactured by Yamamoto Kasei Co.) and 0.1 g of Pionin A-41C (manufactured by Takemoto Yushi Co.) were dissolved in 17 g of ethyl acetate. Also as an aqueous phase component, 40 g of a 4 mass% aqueous solution of PVA-205 were prepared. The oil phase component and the aqueous phase component were mixed and emulsified with a homogenizer for 10 minutes at 12,000 rpm. The obtained emulsion was added to 25 g of distilled water, and the mixture was agitated for 30 minutes at the room temperature and then for 3 hours at 40°C. A microcapsule liquid thus obtained was diluted with distilled water so as to obtain a solid concentration of 15 mass%. The microcapsules had an average particle size of 0.2 µm.
infrared absorbing agent (2)

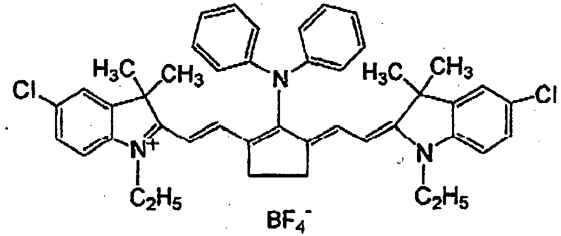

### <Lithographic printing plate precursor (7) and a comparative lithographic printing plate precursor (2')>

A lithographic printing plate precursor (7) and a lithographic printing plate precursor (2') for comparison were obtained in the same manner as the preparation of the lithographic printing plate precursor (6) except that the water-insoluble polymer (6) therein was changed to a water-insoluble polymer (7) and a water-soluble polymer shown in Table 2.

**Table 2: water-insoluble polymers for lithographic printing plate precursors (7) and (2')**

| lithographic printing plate precursor | water-insoluble polymer | solubility | Tg |
|---|---|---|---|
| (7) | 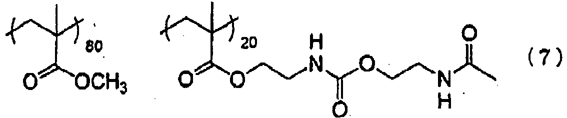 | water-insoluble | 67°C |
| (2') | 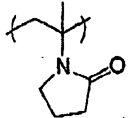 | water soluble | 175°C |
| | (water-soluble polymer) | | |

### <Lithographic printing plate precursor (8)>

An image recording layer coating liquid (3) described above was bar coated on the substrate (A), then oven dried for 60 seconds at 100°C to form an image recording layer of a dry coating amount of 1.0 g/m², further coated thereon with a protective layer coating liquid (1) described above so as to obtain a dry coating amount of 0.2 g/m² and dried for 1 minute at 120°C, thereby obtaining a lithographic printing plate precursor (8).

### <Lithographic printing plate precursors (9) - (11)>

Lithographic printing plate precursors (9) - (11) were obtained in the same manner as the preparation of the lithographic printing plate precursor (8) except that the substrate (A) therein was replaced respectively by a substrate (B), a substrate (C) and a substrate (D).

### <Lithographic printing plate precursor (12)>

An image recording layer coating liquid (4) of a following composition was bar coated on the substrate (A), then oven dried for 60 seconds at 100°C to form an image recording layer of a dry coating amount of 1.4 g/m², further coated thereon with a protective layer coating liquid (1) of a composition described above so as to obtain a dry coating amount of 0.5 g/m² and dried for 1 minute at 120°C, thereby obtaining a lithographic printing plate precursor (12).

### Image recording layer coating liquid (4)

| | | |
|---|---|---|
| water-insoluble polymer (6) described above | | 2.0 g |
| polymerizable compound | | 1.5 g |
| | isocyanuric acid EO denatured triacrylate | |
| | (Aronix M-315, manufactured by Toa Gosei Co.) | |
| following compound (1) | | 0.15 g |
| following compound (2) | | 0.20 g |
| following compound (3) | | 0.4 g |
| ethyl violet | | 0.1 g |
| thermal polymerization inhibitor | | 0.1 g |
| | N-nitrosophenylhydroxyl amine aluminum salt | |
| water-soluble fluorinated surfactant (1) described above | | 0.02 g |
| tetraethylamine hydrochlorate | | 0.06 g |
| 1-methoxy-2-propanol | | 17.5 g |
| methyl ethyl ketone | | 19.0 g |

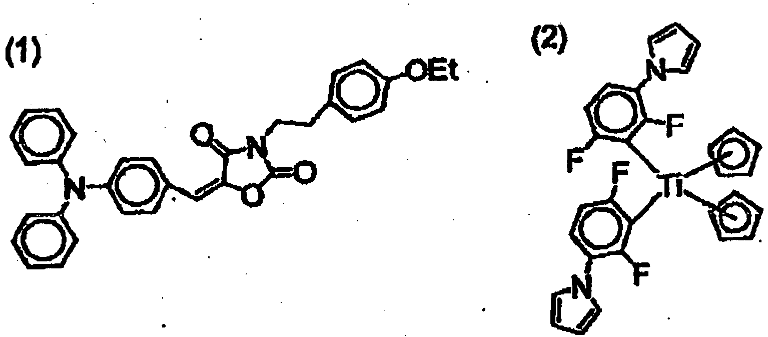

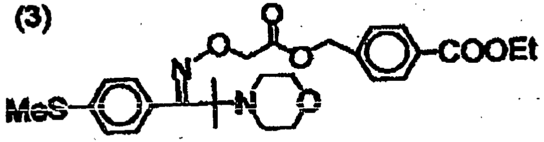

### 2. Evaluation of platemaking

Each of the obtained lithographic printing plate precursors (1) - (4), (6) - (11) and the comparative lithographic printing plate precursors (1') and (2') was subjected to an imagewise exposure on a Trendsetter 3244VX, manufactured by Creo Inc., mounted with a 40W water-cooled infrared semiconductor laser, under conditions of an output of 9 W, a revolution of an external drum of 210 rpm, and a resolution of 2400 dpi.

The lithographic printing plate precursor of Example 5 was subjected to an imagewise exposure with a 375-nm semiconductor laser of an output of 10 mW, under a condition of an energy density of 3 mJ/cm².

The lithographic printing plate precursor of Example 12 was subjected to an imagewise exposure with a 405-nm semiconductor laser of an output of 10 mW, under a condition of an energy density of 3 mJ/cm².

Then a removability of an unexposed area of the image recording layer was evaluated by a development test with a developing equipment as shown in Fig. 1. The test was conducted utilizing ion exchanged water as a processing solution, at temperatures of 25, 60 and 90°C. In Fig. 1, conveying rollers 108 were set at a passing time of 15 seconds from an entrance to an exit. A rotary brush 112 was rotated in a direction forward to the conveying direction, with a speed of 280 mm/sec. 106 denotes a developing tank.

The processed lithographic printing plate was subjected to a visual observation of a non-image area, and the developing property was rated as (+) in case the development was satisfactory and the image recording layer did not remain, or as (-) in case the development was unsatisfactory with an insufficient removal of the image recording layer. Results are shown in Table 3

**Table 3. Evaluation of developing property**

| | Lithographic printing plate precursor | Properties of water-insoluble polymer | | Developing property | | |
|---|---|---|---|---|---|---|
| | | Solubility | Tg (°C) | liquid temp. 90°C | liquid temp. 60°C | liquid temp. 25°C |
| Ex. 1 | (1) | water-insoluble | 45 | + | + | - |
| Ex. 2 | (2) | water-insoluble | 49 | + | + | - |
| Ex. 3 | (3) | water-insoluble | 77 | + | - | - |
| Ex. 4 | (4) | water-insoluble | 9 | + | + | + |
| Ex. 5 | (5) | water-insoluble | 45 | + | + | - |
| Ex. 6 | (6) | water-insoluble | 30 | + | + | - |
| Ex. 7 | (7) | water-insoluble | 67 | + | - | - |
| Ex. 8 | (8) | water-insoluble | 30 | + | + | - |
| Ex. 9 | (9) | water-insoluble | 30 | + | + | - |
| Ex. 10 | (10) | water-insoluble | 30 | + | + | - |
| Ex. 11 | (11) | water-insoluble | 30 | + | + | - |
| Ex. 12 | (12) | water-insoluble | 30 | + | + | - |
| Comp.Ex. 1 | (1') | water-insoluble | 105 | - | - | - |
| Comp.Ex. 2 | (2') | water-soluble | 175 | + | + | + |

### 3. Evaluation of run length

The processed lithographic printing plate, obtained above, was gummed by coating a gum GU-7 manufactured by Fuji Photo Film Co., and was subjected to a printing durability test on a printing press SOR-M, manufactured by Heidelberg GmbH at a printing speed of 6,000 sheets/hr, employing a fountain solution (etching solution EU-3, manufactured by Fuji Photo Film Co.)/water/isopropyl alcohol = 1/89/10 (volumic ratio)) and a black ink TRANS-G(N) (manufactured by Dai-Nippon Inks and Chemicals Ltd.). With the progress of the printing, the image recording layer was gradually abraded to show a decrease in the ink receptivity, thus resulting in a lowering in the ink density on the printing paper. A run length was evaluated by a number of prints when the ink density (reflective density) was lowered by 0.1 in comparison with that at the start of printing. Results are shown in Table 4.

**Table 4: Evaluation of run length**

| | Lithographic printing plate precursor | Developing temp. | Run length (in 100s) |
|---|---|---|---|
| Example 1 | (1) | 60°C | 360 |
| Example 2 | (2) | 60°C | 360 |
| Example 3 | (3) | 90°C | 500 |
| Example 4 | (4) | 25°C | 220 |
| Example 5 | (5) | 60°C | 500 |
| Example 6 | (6) | 60°C | 300 |
| Example 7 | (7) | 90°C | 200 |
| Example 8 | (8) | 60°C | 400 |
| Example 9 | (9) | 60°C | 500 |
| Example 10 | (10) | 60°C | 500 |
| Example 11 | (11) | 60°C | 500 |
| Example 12 | (12) | 60°C | 400 |
| Comp. Ex. 1 | (1') | not developable | |
| Comp. Ex. 2 | (2') | 25°C | 20 |

### [Examples 13 - 21 and Comparative Examples 3, 4]

### 1. Preparation of lithographic printing plate precursor

### <Lithographic printing plate precursors (A) and (B)>

An undercoating liquid (1) described above was coated on a base plate S, obtained in the preparation of the substrate, so as to obtain a dry coating amount of 10 mg/m² to obtain a substrate E to be employed in following experiments.

An image recording layer coating liquid (5) of a following composition was bar coated on the substrate E, and oven dried for 75 seconds at 100°C to form an image recording layer of a dry coating amount of 1.0 g/m², thereby obtaining a lithographic printing plate precursor A. The lithographic printing plate precursor was further coated with a protective layer coating liquid (2) of a following composition so as to obtain a dry coating amount of 1.0 g/m² and oven dried for 90 seconds at 100°C, thereby obtaining a lithographic printing plate precursor B.

The image recording layer coating liquid (5) was obtained by mixing a following photosensitive liquid (2) and a microcapsule liquid (2) under agitation, immediately before the coating.

### Photosensitive liquid (2)

| | |
|---|---|
| water-insoluble polymer (6) | 0.162 g |
| polymerization initiator (1) | 0.100 g |
| following infrared absorbing agent (2) | 0.020 g |
| polymerizable compound, Aronix M-215, manufactured by Toa Gosei Co. | 0.385 g |
| fluorinated surfactant (1) | 0.044 g |
| methyl ethyl ketone | 1.091 g |
| 1-methoxy-2-propanol | 8.609 g |

### Microcapsule liquid (2)

| | |
|---|---|
| microcapsules synthesized as follows | 2.640 g |
| water | 2.425 g |

### Synthesis of microcapsules (2)

As an oil phase component, 10 g of a trimethylolpropane-xylene diisocyanate addition product (Takenate D-110N, 75% solution in ethyl acetate, manufactured by Mitsui-Takeda Chemical Co.), 6.00 g of Aronix M-215 (manufactured by Toa Gosei Co.) and 0.12 g of Pionin A-41C (manufactured by Takemoto Yushi Co.) were dissolved in 16.67 g of ethyl acetate. Also as an aqueous phase component, 37.5 g of a 4 mass% aqueous solution of PVA-205 were prepared. The oil phase component and the aqueous phase component were mixed and emulsified with a homogenizer for 10 minutes at 12,000 rpm. The obtained emulsion was added to 25 g of distilled water, and the mixture was agitated for 30 minutes at the room temperature and then for 2 hours at 40°C. A microcapsule liquid thus obtained was diluted with distilled water so as to obtain a solid concentration of 15 mass%. The microcapsules had an average particle size of 0.2 µm.

### Protective layer coating liquid (2)

| | |
|---|---|
| water | 88 g |
| polyvinyl alcohol PV-105 (manufactured by Kuraray Co.) | 10 g |
| polyethylene glycol (molecular weight 2,000) | 2 g |
| following surfactant | 1 g |

### surfactant

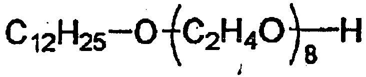

### <Lithographic printing plate precursor C>

An image recording layer coating liquid (6) of a following composition, containing microcapsules (3) of a following synthesis example was bar coated on the substrate E, and oven dried for 120 seconds at 70°C to obtain a dry coating amount of 1.0 g/m², thereby obtaining a lithographic printing plate precursor C.

### Image recording layer coating liquid (6)

| | |
|---|---|
| water | 27.0 g |
| microcapsule liquid (3) of following synthesis example | 9.0 g |
| acid precursor (following compound B) | 0.24 g |

### compound B

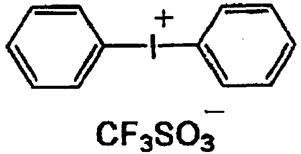

### Synthesis of microcapsules (3)

As an oil phase component, 4.5 g of bis(vinyloxyethyl) ether of bisphenol-A, 5 g of a trimethylolpropane-xylylene diisocyanate addition product (Takenate D-110N, microcapsule wall material, manufactured by Mitsui-Takeda Chemical Co.), 3.75 g of Millionate MR-200 (aromatic isocyanate oligomer, microcapsule wall material, manufactured by Nippon Polyurethane Co.), 1.5 g of a following infrared absorbing agent (3), and 0.1 g of Pionin A-41C (manufactured by Takemoto Yushi Co.) were dissolved in 18.4 g of ethyl acetate. Also as an aqueous phase component, 37.5 g of a 4 mass% aqueous solution of PVA-205 (polyvinyl alcohol, saponification degree: 88 mol.%) were prepared. The oil phase component and the aqueous phase component were mixed and emulsified with a homogenizer for 10 minutes at 12,000.rpm. Then 0.38 g of tetraethylene pentamine (5-functional amine, crosslinking agent for microcapsule wall) dissolved in 26 g of water were added, and the mixture was agitated for 30 minutes under water cooling and then for 3 hours at 65°C. A microcapsule liquid thus obtained had a solid concentration of 24 mass% and an average particle size of 0.3 µm.

### infrared absorbing agent (3)

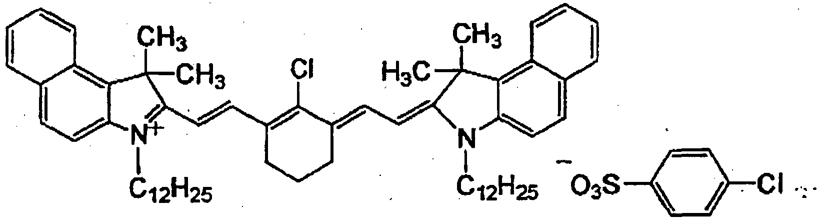

### <Lithographic printing plate precursor D>

An image recording layer coating liquid (7) of a following composition was bar coated on the substrate E, then oven dried for 60 seconds at 100°C to obtain an image recording layer of a dry coating amount of 1.0 g/m², further bar coated with a protective layer coating liquid (2) described above so as to obtain a dry coating amount of 1.0 g/m² and dried for I minute at 120°C thereby obtaining a lithographic printing plate precursor D.

### Image recording layer coating liquid (7)

| | | |
|---|---|---|
| polymerization initiator (2) | | 0.2 g |
| water-insoluble polymer (6) | | 12.0 g |
| polymerizable compound, Aronix M-315 (manufactured by Toa Gosei Co.) | | 6.0 g |
| following compound C-1 | | 1.5 g |
| leuco crystal violet | | 3.0 g |
| thermal polymerization inhibitor | | 0.1 g |
| | N-nitrosophenylhydroxyl amine aluminum salt | |
| fluorinated surfactant (1) | | 0.1 g |
| methyl ethyl ketone | | 70.0 g |
| compound C-1 | | |

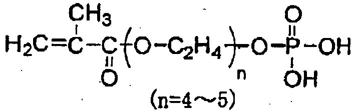

### <Lithographic printing plate precursor E>

An image recording layer coating liquid (4) described before was bar coated on the substrate E, then oven dried for 60 seconds at 100°C to obtain an image recording layer of a dry coating amount of 1.4 g/m², further bar coated thereon with a protective layer coating liquid (2) described above so as to obtain a dry coating amount of 1.0 g/m² and dried for 1 minute at 120°C thereby obtaining a lithographic printing plate precursor E.

### [Preparation of processing solution]

Processing solutions 1 - 5 were prepared with formulations shown in Table 5, in which amounts are represented by [g].

**Table 5 Formulations of processing solutions**

| | process solution 1 | process solution 2 | process solution 3 | process solution 4 | process solution 5 |
|---|---|---|---|---|---|
| water | 9310 | 9185 | 9340 | 9130 | 9185 |
| N-phenyldiethanolamine | | | | | 100 |
| benzyl alcohol | 150 | | | 150 | |
| N-phenylethanolamine | | 100 | 100 | | |
| polyvinyl alchol PVA-105 (Kuraray Co.) | | | 30 | | |
| gum Arabic | 150 | 150 | | 150 | 150 |
| enzyme-denatured potato starch | 400 | 400 | 400 | | 400 |
| soybean polysaccharide (10% aq soln., vis: 14 -18 mPa/sec) | | | | 400 | |
| dioctylsulfosuccinate ester sodium salt | 50 | 50 | | 50 | 50 |
| polyoxyethylene (10 addition moles) diglycerin | | | 50 | | |
| ammonium primary phosphate | 10 | 10 | 10 | 10 | 10 |
| citric acid | 10 | | 10 | 10 | |
| sodium hexametaphosphate | | 5 | | | 5 |
| EDTA tetrasodium salt | 10 | 10 | 10 | 10 | 10 |
| ethylene glycol | 90 | 90 | | 90 | 90 |
| glycerin | | | 50 | | |
| total | 10000 | 10000 | 10000 | 10000 | 10000 |

### 2. Execution of planographic printing method

The planographic printing method of the invention was executed with the lithographic printing plate precursors A - E and the processing solutions 1 - 5 in combinations shown in Table 6, executing an exposure, a processing and a printing as described in the following.

### <Exposure and processing>

Each of the obtained lithographic printing plate precursors A - C was subjected to an imagewise exposure on a Trendsetter 3244VX, manufactured by Creo Inc., mounted with a 40W water-cooled infrared semiconductor laser, under conditions of an output of 9 W, a revolution of an external drum of 210 rpm, and a resolution of 2400 dpi. The lithographic printing plate precursor D was subjected to an imagewise exposure with a 375-nm semiconductor laser of an output of 10 mW, under a condition of an energy density of 3 mJ/cm². Also the lithographic printing plate precursor E was subjected to an imagewise exposure with a 405-nm semiconductor laser of an output of 10 mW, under a condition of an energy density of 3 mJ/cm².

Then a processing was carried out with a developing equipment as shown in Fig. 1, with the processing solution of a temperatures of 25°C. In Fig. 1, conveying rollers 108 were set at a passing time of 15 seconds from an entrance to an exit. A rotary brush 112 was rotated in a direction forward to the conveying direction, with a speed of 280 mm/sec. The lithographic printing plate precursor discharged from the processing tank was spontaneously dried. In an observation of the lithographic printing plate precursor after drying, the non-image area was removed in Examples 13, 18 and 19, but not removed in other examples.

### <Printing>

The spontaneously dried lithographic printing plate precursor was mounted on a cylinder of a printing press SOR-M, manufactured by Heidelberg GmbH. A printing operation was conducted on 500 sheets at a printing speed of 6,000 sheets/hr, employing a fountain solution (etching solution EU-3, manufactured by Fuji Photo Film Co.)/water/isopropyl alcohol = 1/89/10 (volumic ratio)) and a black ink TRANS-G(N) (manufactured by Dai-Nippon Inks and Chemicals Ltd.) and under the supply of the fountain solution and the ink.

The number of printing sheets, required until the unexposed area of the image recording layer was developed and the ink was no longer transferred onto the printing sheet, was measured as an on-press development sheet number.

Also in an initial period of the printing, the exposed area of the image recording layer has a limited adhering ink amount, because of a large amount of water-soluble component remaining thereon, thereby resulting in a low ink density transferred onto the printing sheet. As the water-soluble component on the exposed area of the image recording layer gradually decreases with the progress of the printing, the ink density on the printing sheet gradually increases with an increase in the number of the pnnting sheets. A number of printing sheets where the ink density becomes same as that on a 500th sheet was measured as an inking sheet number. Results are shown in Table 6.

**Table 6: Examples 13 - 21 and Comparative Examples 3, 4**

| | lithographic printing plate precursor | processing solution | on-press development sheet number | inking sheet number |
|---|---|---|---|---|
| Example 13 | lithographic printing plate precursor B | processing solution 1 | 15 | 15 |
| Example 14 | lithographic printing plate precursor B | processing solution 2 | 20 | 20 |
| Example 15 | lithographic printing plate precursor B | processing solution 3 | 20 | 20 |
| Example 16 | lithographic printing plate precursor B | processing solution 4 | 20 | 20 |
| Example 17 | litographic printing plate precursor B | processing solution 5 | 20 | 25 |
| Example 18 | lithographic printing plate precursor A | processing solution 1 | 15 | 15 |
| Example 19 | lithographic printing plate precursor C | processing solution 2 | 15 | 30 |
| Example 20 | lithographic pririting plate precursor D | processing solution 1 | 15 | 15 |
| Example 21 | lithographic printing plate precursor E | processing solution 1 | 15 | 15 |
| Comp. Ex. 3 | lithographic printing plate precursor B | no processing | 50 | 300 |
| Comp. Ex. 4 | lithographic printing plate precursor B | water | 100 | 50 |

Based on the foregoing results, Examples 13 - 21 of the invention were evidently superior in the on-press developability and the inking property to Comparative Examples of no processing and processing with water.

The invention thus provides a platemaking method for a negative lithographic printing plate which is satisfactory in the developing property and the run length, and is developable with an aqueous solution. Also the invention provides a planographic printing method excellent in the developing property and the inking property.

## Claims

1. A planographic printing method comprising:
imagewise exposing a lithographic printing plate precursor comprising an image recording layer removable with at least one of a printing ink and a fountain solution, so as to cure an exposed portion of the image recording layer;
contacting the lithographic printing plate precursor with an aqueous solution containing a hydrophobic organic compound and a water-soluble polymer compound; and
supplying a printing ink and a fountain solution, so as to execute a printing operation.

2. A planographic printing method according to Claim 1, wherein the image recording layer includes (1) a polymerization initiator and (2) a polymerizable compound.

3. A planographic printing method according to Claim 1, wherein the image recording layer includes microcapsules.

4. A planographic printing method according to Claim. 1, wherein the image recording layer is ultraviolet sensitive.

5. A planographic printing method according to Claim 1, wherein the image recording layer is infrared sensitive.

6. A planographic printing method according to Claim 1, wherein the imagewise exposure is executed with a laser emitting a light of a wavelength within a range of 760 to 1200 nm.

7. A planographic printing method according to Claim 1, wherein the imagewise exposure is executed with a laser emitting a light of a wavelength within a range of 250 to 420 nm.

8. A planographic printing method according to Claim 1,wherein the content of the water-soluble polymer compound in the aqueous solution is 0.1-20 mass %.

9. A planographic printing method according to Claim 1, wherein the aqueous solution further comprises a chelate compound.

10. A planographic printing method according to Claim 1, wherein the lithographic printing plate further comprises:
a substrate; and
an undercoat layer comprising a compound having a polymerizable group and a group adsorbable to the substrate selected from a sulfonic acid group, a phosphoric acid group and a phosphate ester,
wherein the substrate, the undercoat layer and the image recording layer are provided in this order.

## Patentansprüche

1. Flachdruckverfahren umfassend
das bildweise Belichten eines Lithographiedruckplattenvorläufers umfassend eine Bildaufzeichnungsschicht, die mit wenigstens einem von einer Drucktinte und einer Feuchtlösung entfernbar ist, sodass der belichtete Teil der Bildaufzeichnungsschicht gehärtet wird;
Inkontaktbringen des Lithographiedruckplattenvorläufers mit einer wässrigen Lösung, die eine hydrophobe organische Verbindung und eine wasserlösliche Polymerverbindung enthält und
Zuführen einer Drucktinte und einer Feuchtlösung um einen Druckvorgang durchzuführen.

2. Flachdruckverfahren gemäß Anspruch 1, worin die Bildaufzeichnungsschicht (1) einen Polymerisationsstarter und (2) eine polymerisierbare Verbindung umfasst.

3. Flachdruckverfahren gemäß Anspruch 1, worin die Bildaufzeichnungsschicht Mikrokapseln umfasst.

4. Flachdruckverfahren gemäß Anspruch 1, worin die Bildaufzeichnungsschicht Ultraviolett-empfindlich ist.

5. Flachdruckverfahren gemäß Anspruch 1, worin die Bildaufzeichnungsschicht Infrarot-empfindlich ist.

6. Flachdruckverfahren gemäß Anspruch 1, worin das bildweise Belichten mit einem Laser durchgeführt wird, der Licht einer Wellenlänge innerhalb eines Bereichs von 760 bis 1200 nm emittiert.

7. Flachdruckverfahren gemäß Anspruch 1, worin das bildweise Belichten mit einem Laser durchgeführt wird, der Licht einer Wellenlänge innerhalb eines Bereichs von 250 bis 420 nm emittiert.

8. Flachdruckverfahren gemäß Anspruch 1, worin der Gehalt der wasserlöslichen Polymerverbindung in der wässrigen Lösung 0,1 bis 20 Massen-% beträgt.

9. Flachdruckverfahren gemäß Anspruch 1, worin die wässrige Lösung ferner eine Chelatverbindung umfasst.

10. Flachdruckverfahren gemäß Anspruch 1, worin der Lithographiedruckplattenvorläufer ferner umfasst:
ein Substrat und
eine Unterzugsschicht umfassend eine Verbindung mit einer polymerisierbaren Gruppe und einer Gruppe, die an das Substrat adsorbierbar ist, ausgewählt aus einer Sulfonsäuregruppe, einer Phosphorsäuregruppe und einem Phosphatester,
worin das Substrat, die Unterzugsschicht und die Bildaufzeichnungsschicht in dieser Reihenfolge angeordnet sind.

## Revendications

1. Procédé d'impression planographique comprenant les étapes consistant à :
exposer selon une image un précurseur de plaque d'impression lithographique comprenant une couche d'enregistrement d'image pouvant être éliminée avec au moins l'une parmi une encre d'impression et une solution de mouillage, de manière à durcir une partie exposée de la couche d'enregistrement d'image;
mettre en contact le précurseur de plaque d'impression lithographique avec une solution aqueuse contenant un composé organique hydrophobe et un composé polymère soluble dans l'eau ; et
fournir une encre d'impression et une solution de mouillage, de manière à exécuter une opération d'impression.

2. Procédé d'impression planographique selon la revendication 1, dans lequel la couche d'enregistrement d'image comprend (1) un initiateur de polymérisation et (2) un composé polymérisable.

3. Procédé d'impression planographique selon la revendication 1, dans lequel la couche d'enregistrement d'image comprend des microcapsules.

4. Procédé d'impression planographique selon la revendication 1, dans lequel la couche d'enregistrement d'image est sensible aux ultraviolets.

5. Procédé d'impression planographique selon la revendication 1, dans lequel la couche d'enregistrement d'image est sensible aux infrarouges.

6. Procédé d'impression planographique selon la revendication 1, dans lequel l'exposition selon une image est exécutée avec un laser émettant une lumière à une longueur d'onde dans une plage de 760 à 1200 nm.

7. Procédé d'impression planographique selon la revendication 1, dans lequel l'exposition selon une image est exécutée avec un laser émettant une lumière à une longueur d'onde dans une plage de 250 à 420 nm.

8. Procédé d'impression planographique selon la revendication 1, dans lequel la teneur en composé polymère soluble dans l'eau est de 0,1-20% en masse dans la solution aqueuse.

9. Procédé d'impression planographique selon la revendication 1, dans lequel la solution aqueuse contient en outre un chélate.

10. Procédé d'impression planographique selon la revendication 1, dans lequel la plaque d'impression lithographique comprend de plus :
un support ; et
une sous-couche comprenant un composé comptant un groupe polymérisable et un groupe adsorbable sur le support, choisi parmi un groupe acide sulfonique, un groupe acide phosphorique et un ester phosphorique,
dans lequel le support, la sous-couche et la couche d'enregistrement d'image sont prévus dans cet ordre.
